# EUROPÄISCHE PATENTANMELDUNG

(11) **EP 2 244 489 A1**
(43) Veröffentlichungstag der Anmeldung: **27.10.2010**
(21) Anmeldenummer: 09005740.7
(22) Anmeldetag: 24.04.2009
(51) Int. Cl.: H04R 7/08, H04R 17/00, H01L 41/107, H01L 41/113

(54) **Verfahren zur Herstellung eines elektromechanischen Wandlers**

(71) Anmelder: Bayer MaterialScience AG, 51368 Leverkusen (DE)
(72) Erfinder: Jenninger, Werner, Dr., 50674 Köln (DE); Wagner, Joachim, Dr., 51061 Köln (DE); Fischer, Wolfgang, Dr., 40668 Meerbusch (DE); Büchner, Jörg, 51467 Bergisch Gladbach (DE); Bernert, Thomas. Dr., 51377 Leverkusen (DE); Nuebler, Andreas, 84030 Landshut (DE)

(57) **Zusammenfassung**

Die vorliegende Erfindung betrifft ein Verfahren zur Herstellung eines elektromechanischen, beispielsweise piezoelektrischen, Wandlers, in dem eine erste Aussparungen (3;3a) umfassende Polymerschicht (2;2a) auf eine erste durchgehende Polymerschicht (1;1a) mittels eines Druck- und/oder Beschichtungsverfahrens aufgebracht wird, eine Abdeckung (4;1b,2b) auf die erste Aussparungen (3;3a) umfassende Polymerschicht (2;2a) so aufgebracht wird, dass die Aussparungen (3;3a) der ersten Aussparungen (3;3a) umfassenden Polymerschicht (2;2a) unter Ausbildung von Hohlräumen (5) verschlossen werden und die Abdeckung (4;1b,2b) mit der ersten Aussparungen (3;3a) umfassenden Polymerschicht (2;2a) verbunden wird. Die Erfindung betrifft weiterhin elektromechanische Wandler, welche durch ein erfindungsgemäßes Verfahren herstellbar sind, sowie deren Verwendung.

## Beschreibung

Die vorliegende Erfindung betrifft ein Verfahren zur Herstellung eines elektromechanischen, beispielsweise piezoelektrischen, Wandlers, elektromechanische Wandler sowie deren Verwendung.

Die Fähigkeit einiger Materialien, ein elektrisches Potential aufgrund einer ausgeübten mechanischen Belastung auszubilden, bezeichnet man als Piezoelektrizität. Etablierte piezoelektrische Materialien sind Blei-Zirkonium-Titanat (PZT) und fluorierte Polymere wie Polyvinylidenfluorid (PVDF). Piezoelektrisches Verhalten wurde auch in geschäumtem, geschlossenporigen Polypropylen (PP) beobachtet. Um Piezoelektrizität zu erreichen, wird ein solcher Polypropylenschaum in einem hohen elektrischen Feld aufgeladen. Dadurch fmden innerhalb der Poren elektrische Durchschläge statt, welche Makrodipole generieren und das Material makroskopisch polarisieren. Derartige Polypropylenferroelektrete können einen piezoelektrischen Koeffizienten von einigen Hundert Pikocoulomb pro Newton aufweisen. Um die Sensitivität der Sensorwirkung weiter zu erhöhen, wurden Mehrschichtsysteme aus mehreren übereinander gestapelten Schäumen entwickelt.

Gerhard et al. (2007 Annual Report Conference on Electrical Insulation and Dielectric Phenomena, Seiten 453 bis 456) beschreibt ein Dreischichtferroelektret, in dem ein Polytetrafluorethylenfilm, welcher durch mechanisches oder laserbasiertes Bohren mit einer Vielzahl von gleichförmigen, durchgehenden Aussparungen versehen wurde, zwischen zwei gleichförmigen Fluorethylenpropylenfilmen angeordnet ist. Das Einbringen von durchgehenden Aussparungen durch mechanisches oder laserbasiertes Bohren ist jedoch aufwendig und für die Produktion großer Stückzahlen ungeeignet.

Wünschenswert wäre, ein Verfahren zur Herstellung eines elektromechanischen, beispielsweise piezoelektrischen, Wandlers zur Verfügung zu stellen, welches zur Produktion großer Stückzahlen geeignet ist.

Erfindungsgemäß vorgeschlagen wird daher ein Verfahren zur Herstellung eines elektromechanischen, beispielsweise piezoelektrischen, Wandlers, umfassend die Schritte:
A) Aufbringen einer ersten Aussparungen (3;3a) umfassenden Polymerschicht (2;2a) auf eine erste durchgehende Polymerschicht (1;1a) mittels eines Druck- und/oder Beschichtungsverfahrens;
B) Aufbringen einer Abdeckung (4;1b,2b) auf die erste Aussparungen (3;3a) umfassende Polymerschicht (2;2a), so dass die Aussparungen (3;3a) der ersten Aussparungen (3;3a) umfassenden Polymerschicht (2;2a) unter Ausbildung von Hohlräumen (5) verschlossen werden; und
C) Verbinden der Abdeckung (4;1b,2b) mit der ersten Aussparungen (3;3a) umfassenden Polymerschicht (2;2a).

Durch das erfindungsgemäße Verfahren können vorteilhafterweise elektromechanische Wandler in großen Stückzahlen hergestellt werden.

Weiterhin können die Aussparungen durch das erfmdungsgemäße Verfahren in zahlreichen unterschiedlichen Formen ausgebildet werden. Die Form der Aussparung ist daher nicht auf eine zylindrische Form mit einer kreisförmigen Querschnittsfläche beschränkt. Darüber hinaus bietet das erfmdungsgemäße Verfahren die Möglichkeit, in unterschiedlichen Formen ausgebildete Aussparungen zu kombinieren. Auf diese Weise kann zum einen vorteilhafterweise das Gesamthohlraumvolumen der resultierenden Hohlräume maximiert werden. Zum anderen können die elektromechanischen, insbesondere piezoelektrischen, Eigenschaften der mit dem erfindungsgemäßen Verfahren hergestellten elektromechanischen Wandler durch Auswahl der Aussparungsform, Anordnung und/oder Verteilung angepasst werden.

Darüber hinaus können durch das erfindungsgemäße Verfahren Grate und andere scharfkantige Aussparungsoberflächenunregelmäßigkeiten vermieden werden, was sich vorteilhaft auf die elektromechanischen, insbesondere piezoelektrischen, Eigenschaften auswirken könnte.

Die Aussparungen umfassende Polymerschicht kann den herzustellenden elektromechanischen Wandler vorteilhafterweise entlang seiner Dicke weicher machen, damit dessen Elastizitätsmodul erniedrigen, einen Polungsprozess in den resultierenden Hohlräumen ermöglichen und/oder nach dem Aufladungsprozess in den durchgehenden Polymerschichten gebildete Ladungsschichten separieren.

In einer Ausführungsform des Verfahrens umfasst die Abdeckung eine zweite Aussparungen umfassende Polymerschicht und eine zweite durchgehende Polymerschicht, wobei die zweite Aussparungen umfassende Polymerschicht auf der zweiten durchgehenden Polymerschicht angeordnet ist. Insbesondere kann dabei die Abdeckung aus einer zweiten Aussparungen umfassenden Polymerschicht und einer zweiten durchgehenden Polymerschicht bestehen.

In einer weiteren Ausführungsform des Verfahrens ist die Abdeckung eine dritte durchgehende Polymerschicht.

In einer weiteren Ausführungsform des Verfahrens wird die Abdeckung durch Aufbringen einer zweiten Aussparungen umfassenden Polymerschicht auf eine zweite durchgehende Polymerschicht mittels eines Druck- und/oder Beschichtungsverfahrens hergestellt.

In einer weiteren Ausführungsform des Verfahrens erfolgt das Verbinden der ersten Aussparungen umfassenden Polymerschicht mit der Abdeckung durch ein Laminierungsverfahren, insbesondere unter erhöhtem Druck und/oder bei einer erhöhten Temperatur und/oder unter Bestrahlung mit ultraviolettem Licht und/oder unter Bestrahlung mit Infrarotlicht. Das Laminieren unter erhöhtem Druck und/oder bei einer erhöhten Temperatur kann beispielsweise zwischen zwei heißen, sich drehenden Zylindern erfolgen. Der Druck und/oder die Temperatur werden dabei vorzugsweise derart ausgewählt, dass sich die Polymerschichten verbinden, wobei die Form der Aussparungen erhalten bleibt. Im Rahmen des Laminierungsverfahrens können die erste Aussparungen umfassende Polymerschicht und/oder die erste durchgehende Polymerschicht und/oder die zweite Aussparungen umfassende Polymerschicht und/oder die zweite durchgehende Polymerschicht erwärmt werden.

Vor dem Laminieren kann das Material der ersten Aussparungen umfassenden Polymerschicht und/oder das Material der zweiten Aussparungen umfassenden Polymerschicht, insbesondere vollständig, verfestigt, beispielsweise vollständig getrocknet und/oder vollständig vernetzt und/oder vollständig erstarrt und/oder vollständig kristallisiert, werden.

Das Material der ersten Aussparungen umfassenden Polymerschicht kann nach dem Aufbringen auf die erste durchgehende Polymerschicht teilweise verfestigt, beispielsweise teilweise getrocknet und/oder teilweise vernetzt und/oder teilweise erstarrt und/oder teilweise kristallisiert, werden. Ebenso kann das Material der zweiten Aussparungen umfassenden Polymerschicht nach dem Aufbringen auf die zweite durchgehende Polymerschicht teilweise verfestigt, beispielsweise teilweise getrocknet und/oder teilweise vernetzt und/oder teilweise erstarrt und/oder teilweise kristallisiert, werden. Insbesondere kann das Material der ersten Aussparungen umfassenden Polymerschicht nach dem Aufbringen auf die erste durchgehende Polymerschicht und/oder das Material der zweiten Aussparungen umfassenden Polymerschicht nach dem Aufbringen auf die zweite durchgehende Polymerschicht so teilweise verfestigt, beispielsweise teilweise getrocknet und/oder teilweise vernetzt und/oder teilweise erstarrt und/oder teilweise kristallisiert, werden, dass dessen Viskosität verglichen mit der Viskosität beim Aufbringen auf die durchgehende Polymerschicht erhöht wird. Auf diese Weise kann zum Einen die Formbeständigkeit der Aussparungen verbessert werden. Zum anderen bietet eine nur teilweise Verfestigung die Möglichkeit, die erste Aussparungen umfassende Polymerschicht mit der dritten durchgehenden Polymerschicht oder der zweiten Aussparungen umfassenden Polymerschicht, durch weiteres, insbesondere vollständiges, Verfestigen des Materials zu verbinden.

In einer weiteren Ausführungsform des Verfahrens erfolgt daher das Verbinden der ersten Aussparungen umfassenden Polymerschicht mit der Abdeckung durch nur teilweises Verfestigen des Materials der ersten Aussparungen umfassenden Polymerschicht nach dem Aufbringen auf die erste durchgehende Polymerschicht, und/oder nur teilweises Verfestigen des Materials der zweiten Aussparungen umfassenden Polymerschicht nach dem Aufbringen auf die zweite durchgehende Polymerschicht, und weiteres, insbesondere vollständiges, Verfestigen des Materials der ersten Aussparungen umfassenden Polymerschicht nach dem Aufbringen der Abdeckung, und/oder weiteres, insbesondere vollständiges, Verfestigen des Materials der zweiten Aussparungen umfassenden Polymerschicht nach dem Aufbringen der Abdeckung. Unter Verfestigen kann dabei Trocknen und/oder Vernetzen und/oder Erstarren und/oder Kristallisieren verstanden werden.

Zum Beispiel ist es möglich, das Material der ersten Aussparungen umfassenden Polymerschicht nach dem Aufbringen auf die erste durchgehende Polymerschicht und/oder das Material der zweiten Aussparungen umfassenden Polymerschicht nach dem Aufbringen auf die zweite durchgehende Polymerschicht, beispielsweise thermisch, zu trocknen und erst nach dem Aufbringen der Abdeckung zu vernetzen.

Ein weiteres Beispiel ist, ein amorph erstarrendes und/oder kristallisierendes Material, insbesondere Polymer, beispielsweise ein Polyurethan, für die erste Aussparungen umfassende Polymerschicht und/oder die zweite Aussparungen umfassende Polymerschicht einzusetzen. Das amorph erstarrende und/oder kristallisierende Material kann beispielsweise als Dispersion unter Ausbildung der ersten beziehungsweise zweiten Aussparungen umfassende Polymerschicht auf die erste beziehungsweise zweite durchgehende Polymerschicht aufgebracht werden. Dabei kann das amorph erstarrende und/oder kristallisierende Material beispielsweise nach dem Aufbringen auf die erste beziehungsweise zweite durchgehende Polymerschicht teilweise amorph erstarren und/oder kristallisieren und nach dem Aufbringen der Abdeckung vollständig amorph erstarren und/oder kristallisieren und dadurch die erste Aussparungen umfassende Polymerschicht mit der Abdeckung verbinden. Das amorph erstarrende und/oder kristallisierende Material kann jedoch auch nach dem Aufbringen auf die erste beziehungsweise zweite durchgehende Polymerschicht vollständig amorph erstarren und/oder kristallisieren und nach dem Aufbringen der Abdeckung vernetzt werden, wobei die erste Aussparungen umfassende Polymerschicht mit der Abdeckung verbunden wird. Weiterhin kann das amorph erstarrende und/oder kristallisierende Material nach dem Aufbringen auf die erste beziehungsweise zweite durchgehende Polymerschicht vollständig amorph erstarren und/oder kristallisieren und nach dem Aufbringen der Abdeckung auf eine Temperatur erwärmt werden, bei der das amorph erstarrende und/oder kristallisierende Material erweicht und/oder schmilzt, wobei die dritte durchgehende Polymerschicht beziehungsweise die andere Aussparungen umfassende Polymerschicht benetzt wird, wobei die Struktur der Aussparungen umfassenden Polymerschicht erhalten bleibt und wobei nach dem Abkühlen auf eine niedrigere Temperatur die erste Aussparungen umfassende Polymerschicht mit der Abdeckung verbunden wird.

Das Material der ersten und/oder zweiten Aussparungen umfassenden Polymerschicht kann beispielsweise thermisch, durch Bestrahlung mit ultraviolettem Licht, durch Bestrahlung mit Infrarotlicht und/oder durch Trocknen vernetzt werden. Insbesondere, wenn eine Schicht Polymere mit einer geringen UV-Stabilität enthält, wie Polycarbonate, kann eine Vernetzung thermisch, durch Bestrahlung mit Infrarotlicht oder durch Trocknen erfolgen.

In einer weiteren Ausführungsform des Verfahrens erfolgt das Aufbringen der ersten Aussparungen umfassenden Polymerschicht und/oder das Aufbringen der zweiten Aussparungen umfassenden Polymerschicht durch Rakeln, Lackschleudern (Spincoating), Tauchlackieren (Dipcoating), Sprühlackieren (Spraycoating), Vorhanggießen (Curtaincoating), Beschichtung mittels Düsenauftrag (Slot-dye-coating), Flexodruck, Gravurdruck, Tampondruck, Digitaldruck, Thermotransferdruck, Durchdruck, insbesondere Hochdruck, Flachdruck, Tiefdruck (Offsetdruck) und/oder Siebdruck, und/oder ein Walzenauftragsverfahren, beispielsweise mit Walzenauftragswerken für Hotmelt-Klebstoffe von der Firma Hardo Maschinenbau GmbH (Bad Salzuflen, Deutschland).

Das Aufbringen der ersten Aussparungen umfassenden Polymerschicht und/oder das Aufbringen der zweiten Aussparungen umfassenden Polymerschicht kann beispielsweise durch Rakeln, Lackschleudern (Spincoating), Tauchlackieren (Dipcoating), Sprühlackieren (Spraycoating) und/oder Vorhanggießen (Curtaincoating) in Kombination mit Matrizen oder Schablonen erfolgen.

In einer weiteren Ausführungsform des Verfahrens erfolgt das Aufbringen der ersten Aussparungen umfassenden Polymerschicht und/oder das Aufbringen der zweiten Aussparungen umfassenden Polymerschicht durch ein Siebdruckverfahren.

Das Aufbringen der ersten Aussparungen umfassenden Polymerschicht und/oder das Aufbringen der zweiten Aussparungen umfassenden Polymerschicht kann mit einem, beispielsweise elektrisch, beheizten Sieb, insbesondere Siebdruckgewebe, erfolgen. Beheizte Siebe für den Siebdruck werden beispielsweise von der Firma Koenen GmbH (Ottobrunn, Deutschland) unter dem Handelsnamen Hot Screen angeboten.

Für beheizte Siebe können beispielsweise thermoplastische Substanzen, wie reaktive und nicht-reaktive Schmelzklebstoffe auf Basis von Polyurethan, Polyester und/oder Polyamid, insbesondere Hot-Melt-Pasten, oder Siebdruckpasten, welche hochsiedende Lösungsmittel umfassen und/oder unter ultraviolettem Licht trocknend sind, als Siebdruckpasten eingesetzt werden.

Die thermoplastischen Substanzen beziehungsweise Hot-Melt-Pasten sind vorzugsweise bei Raumtemperatur fest und erreichen bei den Temperaturen auf die das Sieb aufgeheizt wird, beispielsweise ≥60 °C bis ≤80 °C, eine Viskosität, welche mit der von herkömmlichen Siebdruckpasten vergleichbar ist, beispielsweise von ≥1000 mPa·s bis ≤20000 mPa·s. Der Zusatz von Lösungsmitteln ist bei derartigen Hot-Melt-Pasten nicht erforderlich. Die thermoplastischen Substanzen kühlen beim Kontakt mit der durchgehenden Polymerschicht ab und können dadurch konturscharf stehenbleiben. Neben den konturscharfen Strukturen hat der Einsatz eines beheizten Siebes und einer thermoplastischen Substanz den Vorteil, dass auf einen Trocknungsprozess verzichtet werden kann.

Siebdruckpasten, welche hochsiedende Lösungsmittel umfassen und/oder unter ultraviolettem Licht trocknend sind, können beim Einsatz eines beheizten Siebs, insbesondere Siebdruckgewebes, und gegebenenfalls einer beheizten Rakel aufgebracht werden. Durch die Heizung des Siebs wird die Viskosität der Paste abgesenkt. Bei Berührung der Paste mit der durchgehenden Polymerschicht kühlt die Paste ab und ihre Viskosität steigt an. Dies hat den Vorteil, dass die Konturschärfe erhöht werden kann. In Abhängigkeit von der Feinheit des Siebdruckgewebes können dabei gegebenenfalls auch niederviskose Pasten eingesetzt werden. Unter der Feinheit des Gewebes wird die Zahl der Fäden pro Zentimeter verstanden. Zum Beispiel können Siebdruckgewebe mit einer Fädenzahl von mindestens 120 Fäden pro Zentimeter, insbesondere von mindestens 150 Fäden pro Zentimeter, eingesetzt werden.

Um beim Einsatz eines beheizten Siebes ein Abkühlen der Paste beim Druck zu verhindern und während des Drucks eine optimale Verarbeitbarkeit zu erzielen, können die Druck- und/oder Flutrakel beheizt werden.

Um die Dicke der Aussparungen umfassenden Polymerschichten zu vergrößern, können mehrere Drucke übereinander ausgeführt werden. Zwischen den einzelnen Druckschritten kann das Material der ersten beziehungsweise zweiten Aussparungen umfassenden Polymerschicht teilweise oder vollständig verfestigt, beispielsweise getrocknet und/oder vernetzt und/oder erstarrt und/oder kristallisiert, werden. Gegebenenfalls können die Drucke nass in nass ausgeführt werden. Während durch ein Druckverfahren die Struktur der Aussparungen umfassenden Polymerschicht direkt aufgebracht werden kann, werden die Positionen der späteren Aussparungen in den zuvor beschriebenen Beschichtungsverfahren zunächst abgedeckt oder maskiert.

In einer weiteren Ausführungsform des Verfahrens erfolgt das Aufbringen der ersten Aussparungen umfassenden Polymerschicht und/oder das Aufbringen der zweiten Aussparungen umfassenden Polymerschicht durch Transferbeschichten. Dabei wird unter "Transferbeschichten" insbesondere verstanden, dass die Aussparungen umfassende Polymerschicht zunächst auf einer Transferschicht, beispielsweise ein Trennpapier oder eine Trennfolie, durch ein Druck- und/oder Beschichtungsverfahren, ausgebildet wird und dann auf die durchgehende Polymerschicht übertragen und mit der durchgehenden Polymerschicht verbunden wird. Als Druck- und/oder Beschichtungsverfahren eignen sich dabei die vorgenannten Druck- und/oder Beschichtungsverfahren. Zum Verbinden mit der durchgehenden Polymerschicht eignen sich beispielsweise die zuvor erläuterten Vorgehensweisen auf der Basis von zuerst nur teilweisem und anschließend weiterem, insbesondere vollständigem Verfestigen und das zuvor erläuterte Laminierungsverfahren. Das Transferbeschichten bietet vorteilhafterweise die Möglichkeit der räumlichen und zeitlichen Trennung der Herstellung der ersten und/oder zweiten Aussparungen umfassenden Polymerschicht und des Zusammenfügens der Aussparungen umfassenden Schicht/en mit den durchgehenden Schichten.

In einer weiteren Ausführungsform des Verfahrens sind die Aussparungen der ersten Aussparungen umfassenden Polymerschicht durchgängig durch die erste Aussparungen umfassenden Polymerschicht, insbesondere in Richtung auf die durchgehenden Polymerschichten, ausgebildet und/oder die Aussparungen der zweiten Aussparungen umfassenden Polymerschicht durchgängig durch die zweite Aussparungen umfassende Polymerschicht, insbesondere in Richtung auf die durchgehenden Polymerschichten, ausgebildet. Auf diese Weise kontaktieren die nach Abschluss des erfindungsgemäßen Verfahrens entstehenden Hohlräume auf einer Seite die eine (erste) durchgehende Polymerschicht und auf der anderen Seite die andere (zweite oder dritte) durchgehende Polymehrschicht. Dies wirkt sich wiederum vorteilhaft auf das elektromechanische Verhalten des hergestellten elektromechanischen Energiewandlers aus.

Die erste und/oder zweite Aussparungen umfassende Polymerschicht können im Rahmen der vorliegenden Erfmdung sowohl durch das Bedrucken und/oder Beschichten der ersten beziehungsweise zweiten durchgehenden Polymerschicht mit einer zusammenhängenden Aussparungen umfassenden Polymerschicht als auch durch das Bedrucken und/oder Beschichten der ersten beziehungsweise zweiten durchgehenden Polymerschicht mit gleichen oder unterschiedlichen, isolierten oder miteinander verbundenen Strukturen, beispielsweise Strukturen mit einer eher geringen Fläche, wie Punkte und Linien, beispielsweise gebogene oder gerade, einzelne oder gekreuzte Linien beziehungsweise Umfangslinien von geometrischen Figuren, etwa einer Kreislinie oder einer Umfangslinie eines Kreuzes, oder Strukturen mit einer größeren Fläche, wie gefüllte Rechtecke, Kreise, Kreuze, et cetera, ausgebildet werden. Die Größe und Schichtdicke der Strukturen wird vorzugsweise derart eingestellt, dass sich die durchgehenden Polymerschichten nicht berühren können und/oder dass das nach Fertigstellung resultierende Gesamthohlraumvolumen möglichst groß ist. Im fertig gestellten elektromechanischen Wandler können die erste und/oder zweite Aussparungen umfassende Polymerschicht beispielsweise jeweils eine Schichtdicke von ≥1 µm bis ≤800 µm, insbesondere von ≥10 µm bis ≤400 µm, aufweisen. Insofern bei der Herstellung des elektromechanischen Wandlers nur eine erste Aussparungen umfassende Polymerschicht aufgebracht wird, so kann die erste Aussparungen umfassende Polymerschicht im fertig gestellten elektromechanischen Wandler insbesondere eine Schichtdicke von ≥1 µm bis ≤800 µm, beispielsweise von ≥10 µm bis ≤400 µm, aufweisen. Insofern bei der Herstellung des elektromechanischen Wandlers sowohl eine erste als auch eine zweite Aussparungen umfassende Polymerschicht aufgebracht werden, so kann im fertig gestellten elektromechanischen Wandler die gemeinsame Schichtdicke der ersten Aussparungen umfassenden Polymerschicht und der zweiten Aussparungen umfassenden Polymerschicht ≥1 µm bis ≤800 µm, beispielsweise von ≥10 µm bis ≤400 µm, betragen. Abhängig von den bei der Herstellung des elektromechanischen Wandlers angewandten Druck- und/oder Beschichtungsverfahren und -parametern, kann - beispielsweise beim Einsatz von lösungsmittelhaltigen Druckfarben, Tinten, Pasten, Formulierungen, Lacken oder Klebstoffen - die Schichtdicke der ersten und/oder zweiten Aussparungen umfassenden Polymerschicht direkt nach dem Aufbringen der Aussparungen umfassenden Polymerschicht auf die durchgängige Schicht größer oder sogar deutlich größer als die Schichtdicke der resultierenden Aussparungen umfassenden Polymerschicht im fertig gestellten elektromechanischen Wandler sein. Vorzugsweise werden das Layout, die Druckverfahrenparameter und/oder die Beschichtungsverfahrensparameter derart eingestellt, dass die Aussparungen umfassenden Polymerschichten keine Hohlräume, insbesondere Gaseinschlüsse, aufweisen, welche mit den durchgehenden Polymerschichten nicht in Kontakt stehen.

Die Aussparungen der ersten Aussparungen umfassenden Polymerschicht und die Aussparungen der zweiten Aussparungen umfassenden Polymerschicht können so ausgebildet und angeordnet sein, dass beim Aufbringen der Abdeckung zumindest ein Teil der Aussparungen der ersten Aussparungen umfassenden Polymerschicht und ein Teil der Aussparungen der zweiten Aussparungen umfassenden Polymerschicht teilweise oder vollständig überlappen.

In einer weiteren Ausführungsform des Verfahrens sind die Aussparungen der ersten Aussparungen umfassenden Polymerschicht und die Aussparungen der zweiten Aussparungen umfassenden Polymerschicht so ausgebildet und angeordnet, dass beim Aufbringen der Abdeckung jeweils eine Aussparung der ersten Aussparungen umfassenden Polymerschicht und eine Aussparung der zweiten Aussparungen umfassenden Polymerschicht teilweise oder vollständig überlappen. Das heißt, die Aussparungen der ersten Aussparungen umfassenden Polymerschicht und die Aussparungen der zweiten Aussparungen umfassenden Polymerschicht sind vorzugsweise so ausgebildet und angeordnet, dass beim Aufbringen der Abdeckung jeweils eine Aussparung der ersten Aussparungen umfassenden Polymerschicht und eine Aussparung der zweiten Aussparungen umfassenden Polymerschicht einen gemeinsamen Hohlraum ausbilden. Vorzugsweise sind die Aussparungen der ersten Aussparungen umfassenden Polymerschicht und die Aussparungen der zweiten Aussparungen umfassenden Polymerschicht so ausgebildet und angeordnet, dass jeweils eine Aussparung der ersten Aussparungen umfassenden Polymerschicht und eine Aussparung der zweiten Aussparungen umfassenden Polymerschicht vollständig überlappen. Beispielsweise können die erste und zweite Aussparungen umfassende Polymerschicht dafür deckungsgleich, insbesondere identisch, ausgebildet sein. Auf diese Weise können Hohlräume realisiert werden, welche von der durchgehenden Polymerschicht auf der einen Seite zur durchgehenden Polymerschicht auf der anderen Seite durchgängig sind.

Im Rahmen der vorliegenden Erfindung kann zumindest ein Teil der Aussparungen der ersten Aussparungen umfassenden Polymerschicht und/oder der Aussparungen der zweiten Aussparungen umfassenden Polymerschicht in Formen ausgebildet sein, welche eine Querschnittsfläche, ausgewählt aus der Gruppe bestehend aus im Wesentlichen runden, beispielsweise kreisförmigen, elliptischen oder ovalen, polygonen, beispielsweise dreieckigen, rechteckigen, trapezförmigen, rautenförmigen, fünfeckigen, sechseckigen, insbesondere wabenförmigen, kreuzförmigen, sternförmigen und teilweise runden und teilweise polygonen, beispielsweise S-förmigen, Querschnittsflächen, aufweisen. Die Aussparungen der ersten Aussparungen umfassenden Polymerschicht und/oder die Aussparungen der zweiten Aussparungen umfassenden Polymerschicht können jedoch auch sowohl vollständig in Formen ausgebildet sein, welche eine Querschnittsfläche, ausgewählt aus der Gruppe bestehend aus im Wesentlichen runden, beispielsweise kreisförmigen, elliptischen oder ovalen, polygonen, beispielsweise dreieckigen, rechteckigen, trapezförmigen, rautenförmigen, fünfeckigen, sechseckigen, insbesondere wabenförmigen, kreuzförmigen, sternförmigen und teilweise runden und teilweise polygonen, beispielsweise S-förmigen, Querschnittsflächen, aufweisen, als auch vollständig in davon abweichenden Formen ausgebildet sein.

Im Rahmen einer weiteren Ausführungsform des Verfahrens sind die Aussparungen der ersten Aussparungen umfassenden Polymerschicht und/oder die Aussparungen der zweiten Aussparungen umfassenden Polymerschicht wabenförmig ausgebildet und/oder angeordnet. Eine wabenförmige Ausbildung und Anordnung der Aussparungen hat zum einen ein sehr großes Gesamthohlraumvolumen zur Folge. Zum anderen kann eine wabenförmig Ausbildung und Anordnung der Aussparungen eine hohe mechanische Stabilität aufweisen.

Die Größe der Querschnittsflächen kann bei allen Aussparungen einer Aussparungen umfassenden Polymerschicht gleich oder unterschiedlich sein.

Im Rahmen des erfindungsgemäßen Verfahrens können die Aussparungen in der ersten und/oder zweiten Aussparungen umfassenden Polymerschicht sowohl homogen als auch heterogen verteilt ausgebildet sein. Insbesondere können die Aussparungen in der ersten und/oder zweiten Aussparungen umfassenden Polymerschicht homogen verteilt ausgebildet sein. In Abhängigkeit vom Anwendungsbereich des herzustellenden elektromechanischen Wandlers, kann es jedoch auch vorteilhaft sein, die Aussparungen in der ersten und/oder zweiten Aussparungen umfassenden Polymerschicht, insbesondere gezielt, ortsaufgelöst heterogen verteilt auszubilden.

Die Aussparungen in der ersten und/oder zweiten Aussparungen umfassenden Polymerschicht können gegebenenfalls teilweise oder vollständig miteinander verbunden sein.

In einer weiteren Ausführungsform des Verfahrens umfasst die erste Aussparungen umfassende Polymerschicht und/oder die zweite Aussparungen umfassende Polymerschicht in unterschiedlichen Formen ausgebildete Aussparungen. Insbesondere kann die erste und/oder zweite Aussparungen umfassende Polymerschicht eine Vielzahl an in einer ersten Form ausgebildeten Aussparungen und eine Vielzahl an in einer zweiten Form ausgebildeten Aussparungen und gegebenenfalls eine Vielzahl an in einer dritten Form ausgebildeten Aussparungen, et cetera, aufweisen. Dabei können die in unterschiedlichen Formen ausgebildeten Aussparungen in der ersten beziehungsweise zweiten Aussparungen umfassenden Polymerschicht homogen oder heterogen verteilt und/oder teilweise oder vollständig miteinander verbunden ausgebildet sein. Durch eine Kombination aus in unterschiedlichen Formen ausgebildete Aussparungen kann zum einen vorteilhafterweise das Gesamthohlraumvolumen der resultierenden Hohlräume maximiert werden. Zum anderen können die elektromechanischen, insbesondere piezoelektrischen, Eigenschaften der mit dem erfmdungsgemäßen Verfahren hergestellten, elektromechanischen Wandler durch Auswahl der Aussparungsform, Anordnung und/oder Verteilung angepasst werden.

Insbesondere kann zumindest ein Teil der Aussparungen der ersten und/oder zweiten Aussparungen umfassenden Schicht in Formen ausgebildet sein, welche keine kreisförmige, insbesondere keine im Wesentlichen kreisförmige, Querschnittsfläche aufweisen. Dies liegt darin begründet, dass das Gesamthohlraumvolumen von Schichten, welche ausschließlich Hohlräume mit kreisförmigen oder im wesentlichen kreisförmigen Querschnittsflächen aufweisen, geringer ist als das Gesamthohlraumvolumen beispielsweise bei einer homogen verteilten Anordnung von Hohlräumen mit kreisförmigen und rautenförmigen Querschnittsflächen oder bei einer ausschließlich auf Hohlräumen mit wabenförmigen Querschnittsflächen basierenden Anordnung.

Die erste und zweite Aussparungen umfassende Polymerschicht können grundsätzlich unabhängig voneinander aus jedem Polymer ausgebildet sein, welches geeignet ist, einen Polungsprozess in den Hohlräumen zu ermöglichen und die nach dem Aufladungsprozess in den Polymerfilmen gebildeten Ladungsschichten zu separieren. Beispielsweise können die Aussparungen umfassenden Polymerschichten aus einem Elastomer ausgebildet sein.

Zum Aufbringen der ersten und/oder zweiten Aussparungen umfassenden Polymerschicht beziehungsweise zum Ausbilden der ersten und/oder zweiten Aussparungen umfassenden Polymerschicht kann eine Druckfarbe, eine Tinte, eine Paste, eine Formulierung, ein Lack oder ein Klebstoff eingesetzt werden. Diese können sowohl direkt vor der Verarbeitung formuliert werden als auch kommerziell erhältlich sein.

Beispielsweise kann die Druckfarbe, die Tinte, die Paste, die Formulierung, der Lack oder der Klebstoff beziehungsweise die erste und/oder zweite Aussparungen umfassende Polymerschicht mindestens ein Polymer ausgewählt aus der Gruppe bestehend aus Celluloseestern, Celluloseethern, Kautschukderivaten, Polyesterharzen, ungesättigten Polyestern, Alkydharzen, Phenolharzen, Aminoharzen, Amidoharzen, Ketonharzen, Xylol-Formaldehydharzen, Epoxidharze, Phenoxyharzen, Polyolefinen, Polyvinylchlorid, Polyvinylestern, Polyvinylalkoholen, Polyvinylacetalen, Polyvinylethern, Polyacrylaten, Polymetacrylaten, Polystyrolen Polycarbonaten, Polyestern, Copolyestern, Polyamiden, Silikonharzen, Polyurethanen, insbesondere Polyurethanen, und Mischungen dieser Polymere, insbesondere als Bindemittel, umfassen beziehungsweise daraus ausgebildet sein. Insofern die Druckfarbe, die Tinte, die Paste, die Formulierung, der Lack oder der Klebstoff beziehungsweise die erste und/oder zweite Aussparungen umfassende Polymerschicht ein Harz umfasst, kann die Druckfarbe, die Tinte, die Paste, die Formulierung, der Lack oder der Klebstoff beziehungsweise die erste und/oder zweite Aussparungen umfassende Polymerschicht gegebenenfalls weiterhin einen oder mehrere Harzhärter umfassen.

Weiterhin kann für die Druckfarbe, die Tinte, die Paste, die Formulierung, den Lack oder den Klebstoff beziehungsweise die erste und/oder zweite Aussparungen umfassende Polymerschicht eine Vielzahl von kommerziell erhältlichen Produkten, insbesondere als Bindemittel, geeignet sein, welche beispielsweise unter den Handelsnamen Noriphan HTR, Noriphan PCI, Noriphan N2K, Noricryl und NoriPET von der Firma Pröll KG, Weißenburg in Bayern, Deutschland, oder unter dem Handelsnamen Maraflex FX von der Firma Marabu GmbH & Co. KG, Tamm, Deutschland, oder unter dem Handelsnamen Polyplast PY von der Firma Fujifilm Sericol Deutschland GmbH, Bottrop, Deutschland, oder unter den Handelsnamen Siebdruckfarben HG, SG, CP, CX, PK, J, TL sowie YN von der Firma Coates Screen Inks GmbH, Nürnberg, Deutschland, oder unter den Handelsnamen 1500 Series UV Flexiform, 1600 Power Print Series, 1700 Versa Print, 3200 Series, 1800 Power Print plus, 9700 Series, PP Series, 7200 Lacquer und 7900 Series von der Firma Nazdar, Shawnee, Vereinigte Staaten von Amerika, vertrieben werden.

Für eine Druckfarbe, eine Tinte, eine Paste, eine Formulierung, einen Lack oder einen Klebstoff, welche/r unter ultraviolettem Licht härtet, eignen sich, insbesondere als Bindemittel, beispielsweise Epoxy-, Ester-, Ether- und/oder Urethanacrylate. Urethanacrylate können als Lösungen in Reaktivverdünnern (niederviskose Meth-/Acrylsäureester), als niederviskose Oligomere, als Feststoffe für die Pulverlacktechnologie oder als Urethanacrylat-Dipsersionen eingesetzt werden. Urethanacrylate sind beispielsweise unter dem Handels/Markennamen Desmolux von der Firma Bayer MaterialScience AG (Leverkusen, Deutschland) erhältlich. Zur Härtung eignen sich beispielsweise Elektronenstrahlhärtung, Mono Cure Technologie und Dual Cure Technologie. Für die Dual Cure Technologie sind Isocyanatourethanacryle besonders geeignet.

Die Druckfarbe, die Tinte, die Paste, die Formulierung, der Lack oder der Klebstoff können auf Wasserbasis oder auf der Basis anderer Lösungsmittel als Wasser aufgebaut sein.

Die Druckfarbe, die Tinte, die Paste, die Formulierung, der Lack oder der Klebstoff beziehungsweise die erste und/oder zweite Aussparungen umfassende Polymerschicht kann ein oder mehr Polyurethane umfassen oder daraus ausgebildet sein. Insbesondere können die Druckfarbe, die Tinte, die Paste, die Formulierung, der Lack oder der Klebstoff beziehungsweise die erste und/oder zweite Aussparungen umfassende Polymerschicht ein oder mehrere Einkomponenten-Polyurethane und/oder ein oder mehrere Zweikomponenten-Polyurethane und/oder eine oder mehrer wässrige Polyurethandispersionen und/oder einen oder mehrere Polyurethan-Schmelzklebstoffe umfassen oder daraus ausgebildet sein.

Beispielsweise kann die Druckfarbe, die Tinte, die Paste, die Formulierung, der Lack oder der Klebstoff beziehungsweise die erste und/oder zweite Aussparungen umfassende Polymerschicht ein oder mehrere Einkomponenten-Polyurethane umfassen oder daraus ausgebildet sein, welche Prepolymere, herstellbar durch Reaktion von Alkoholen mit einem stöchiometrischen Überschuss von polyfunktionellen Isocyanaten mit einer mittleren Funktionalität größer als 2 und bis zu 4, umfassen. Dies Prepolymere können gegebenenfalls weiterhin Zusatzstoffe und/oder Lösungsmittel umfassen.

Die Prepolymere können beispielsweise durch Umsetzung von Polyisocyanaten mit Alkoholen, die Mischungen von Polyolen mit im Mittel monofunktionellen Alkoholen darstellen, unter Ausbildung von Urethangruppen und endständigen Isocyanatgruppen erhalten werden.

Als Polyole können die dem Fachmann bekannten, in der Polyurethanchemie üblichen Polyole, wie beispielsweise Polyether-, Polyacrylat-, Polycarbonat-, Polycaprolacton-, Polyurethan- und Polyester-Polyole verwendet werden, wie sie zum Beispiel in Ullmanns Enzyklopädie der technischen Chemie, 4. Auflage, Band 19, S. 304-5, Verlag Chemie, Weinheim, oder in Polyurethan Lacke, Kleb- und Dichtstoffe von Ulrich Meier-Westhues, Vincentz Network, Hannover, 2007, beschrieben sind. Zum Beispiel können die Desmophen ® genannten Polyole der Firma Bayer MaterialScience AG, Leverkusen, Deutschland, verwendet werden.

Als polyfunktionelle Isocyanate mit einer mittleren Funktionalität > 2 können die in der Polyurethanchemie üblichen, dem Fachmann bekannten Produkte eingesetzt werden, wie sie zum Beispiel in Ullmanns Enzyklopädie der technischen Chemie, 4. Auflage, Band 19, S. 303-4, Verlag Chemie, Weinheim, beschrieben sind. Als Beispiele seien über Biuretgruppen trimerisierte Isocyanate, wie etwa trimerisiertes Hexamethylendiisocyanat Desmodur ® N (Handelsname der Firma Bayer MaterialScience AG, Leverkusen, Deutschland), oder deren Gemische mit Diisocyanaten oder über Isocyanuratgruppen trimerisierte Isocyanate oder ihre Gemische mit Diisocyanaten genannt. Auch die Addukte von Diisocyanaten an Polyole, beispielsweise von Toluylendiisocyanat an Trimethylolpropan sind geeignet.

Den Prepolymeren können Zusatzstoffe wie Katalysatoren zur Beschleunigung der Aushärtung, beispielsweise tertiäre Amine wie Dimorpholinodiethylether, Bis-[2-N,N-(dimethylamino)ethyl]ether oder Zinnverbindungen, wie Dibutylzinndilaurat oder Zinn-II-octoat, Alterungs- und Lichtschutzmittel, Trockenmittel, Stabilisatoren, beispielsweise Benzoylchlorid, Haftvermittler zur Verbesserung der Adhäsion, Weichmacher, beispielsweise Dioctylphthalat, sowie Pigmente und Füllstoffe zugegeben werden.

Wegen der Feuchtigkeitsempfindlichkeit der Isocyanate sollte in der Regel unter sorgfältigem Ausschluss von Wasser gearbeitet werden, das heißt es sollten wasserfreie Rohstoffe eingesetzt werden und der Zutritt von Feuchtigkeit während der Reaktion vermieden werden.

Die Herstellung der Prepolymere kann durch Umsetzung des Gemisches aus Polyolen und monofunktionellem Alkohol mit einem stöchiometrischen Überschuss von di- oder polyfunktioneller Isocyanatverbindung erfolgen. Es ist jedoch auch möglich, die monofunktionelle Hydroxylverbindung in einer vorgeschalteten Reaktion mit der Isocyanatverbindung umzusetzen.

Die Druckfarbe, die Tinte, die Paste, die Formulierung, der Lack oder der Klebstoff beziehungsweise die erste und/oder zweite Aussparungen umfassende Polymerschicht kann jedoch auch ein oder mehrere Zweikomponenten-Polyurethane umfassen oder daraus ausgebildet sein, welche beispielsweise eine Komponente mit Isocyanatgruppen und eine isocyanatreaktive Komponente umfassen.

Als geeignete Polyisocyanate für die Druckfarbe, die Tinte, die Paste, die Formulierung, den Lack oder den Klebstoff beziehungsweise die erste und/oder zweite Aussparungen umfassende Polymerschicht können die dem Fachmann an sich bekannten NCO-funktionellen Verbindungen einer Funktionalität von bevorzugt 2 oder mehr Verwendung finden. Dies sind typischerweise aliphatische, cycloaliphatische, araliphatische und/oder aromatische Di- oder Triisocyanate sowie deren höhermolekulare Folgeprodukte mit Iminooxadiazindion-, Isocyanurat-, Uretdion-, Urethan-, Allophanat-, Biuret-, Harnstoff-, Oxadiazintrion, Oxazolidinon-, Acylharnstoff und/oder Carbodiimid-Strukturen, die zwei oder mehr freie NCO-Gruppen aufweisen.

Beispiele für solche Di- oder Triisocyanate sind Tetramethylendiisocyanat, Cyclohexan-1,3- und 1,4-diisocyanat, Hexamethylendiisocyanat (HDI), 1-Isocyanato-3,3,5-trimethyl-5-isocyanatomethyl-cyclohexan (Isophorondiisocyanat, IPDI), Methylen-bis-(4-isocyanatocyclohexan), Tetramethylxylylendiisocyanat (TMXDI), Triisocyanatononan, Toluylendiisocyanat (TDI), Diphenylmethan-2,4'-und/oder -4,4'-und/oder -2,2'-diisocyanat (MDI), Triphenylmethan-4,4'-diisocyanat, Naphtylen-1,5-diisocyanat, 4-Isocyanatomethyl-1,8-octandiisocyanat (Nonantriisocyanat, Triisocyanatononan, TIN) und/oder 1,6,11 - Undecantriisocyanat sowie deren beliebige Mischungen und gegebenenfalls auch Mischungen anderer Di-, Tri- und/oder Polyisocyanate. Solche Polyisocyanate haben typischerweise Isocyanatgehalte von 0,5 Gewichtsprozent bis 60 Gewichtsprozen, bevorzugt 3 Gewichtsprozent bis 30 Gewichtsprozent, besonders bevorzugt 5 Gewichtsprozent bis 25 Gewichtsprozent.

Bevorzugt werden in der Druckfarbe, der Tinte, der Paste, der Formulierung, dem Lack oder dem Klebstoff beziehungsweise der ersten und/oder zweiten Aussparungen umfassenden Polymerschicht die höhermolekularen Verbindungen mit Isocyanurat-, Urethan-, Allophanat-, Biuret-, Iminooxadiazintrion-, Oxadiazintrion- und/oder Uretdiongruppen auf Basis aliphatischer und/oder cycloaliphatischer und/oder aromatischer Diisocyanate eingesetzt.

Besonders bevorzugt werden in der Druckfarbe, der Tinte, der Paste, der Formulierung, dem Lack oder dem Klebstoff beziehungsweise der ersten und/oder zweiten Aussparungen umfassenden Polymerschicht Verbindungen mit Biuret-, Iminooxadiazindion,- Isocyanurat- und/oder Uretdiongruppen auf Basis von Hexamethylendiisocyanat, Isophorondiisocyanat, 4,4'-Diisocyanatodicyclohexylmethan, Diphenylmethan-4,4' -diisocyanat, Diphenylmethan-2,4'-diisocyanat, 2,4-Toluylendiisocyanat, 2,6-Toluylendiisocyanat und/oder Xylylendiisocyanat eingesetzt.

Die Herstellung und/oder Verwendung der isocyanathaltigen Komponente kann in einem Lösemittel erfolgen, Beispiele sind N-Methylpyrrolidon, N-Ethylpyrrolidon, Xylol, Solvent Naphtha, Toluol, Butylacetat, Methoxypropylacetat, Aceton oder Methylethylketon. Es ist möglich, nach der Abreaktion der Isocyanatgruppen Lösemittel hinzu zu geben. Hierbei können auch protische Lösemittel wie Alkohole zum Einsatz kommen, die beispielsweise der Stabilisierung der Lösung oder der Verbesserung von Lackeigenschaften dienen. Es sind auch beliebige Mischungen von Lösemitteln möglich. Die Menge Lösemittels wird im allgemeinen so bemessen, dass 20 gewichtsprozentige bis < 100 gewichtsprozentige, vorzugsweise 50 gewichtsprozentige bis 90 gewichtsprozentige Lösungen resultieren.

Zur Beschleunigung der Vernetzung können auch Katalysatoren zugesetzt werden. Geeignete Katalysatoren sind in "Polyurethane Chemistry and Technology", Volume XVI, Part 1, Abschnitt IV, Seiten 129 - 211, The Kinetics and Catalysis of the Isocyanate Reactions, beschrieben. Beispielsweise sind tertiäre Amine, Zinn-, Zink- oder Wismutverbindungen, oder basische Salze geeignet. Bevorzugt sind Dibutylzinndilaurat und -octoat.

Geeignete isocyanatreaktive Komponenten wie beispielsweise Polyhydroxylverbindungen sind dem Fachmann an sich bekannt. Bevorzugt sind dies die an sich bekannten Bindemittel auf Basis von Polyhydroxypolyestern, Polyhydroxypolyurethanen, Polyhydroxypolyethern, Polycarbonat-Diolen oder von Hydroxylgruppen aufweisenden Polymerisaten, wie den an sich bekannten Polyhydroxypolyacrylaten, Polyacrylatpolyurethanen und/oder Polyurethanpolyacrylaten. Als Beispiele seien die Desmophen ® genannten Polyole der Firma Bayer MaterialScience AG, Leverkusen, Deutschland, genannt.

Die Druckfarbe, die Tinte, die Paste, die Formulierung, der Lack oder der Klebstoff beziehungsweise die erste und/oder zweite Aussparungen umfassende Polymerschicht kann jedoch auch eine oder mehrere wässrige Polyurethandispersionen, beispielsweise eine Polyurethan-Polyharnstoffdispersion, umfassen oder aus einer solchen ausgebildet sein. Geeignete wässrige Polyurethandispersionen zur Formulierung der Druckfarbe, der Tinte, der Paste, der Formulierung, des Lacks oder des Klebstoffs sind solche, wie sie beispielsweise in US 2,479,310 A, US 4,092,286 A, DE 2 811 148 A, DE 3603996 und EP 08019884 beschrieben sind.

Geeignete Diol- und /oder Polyolkomponenten für die Herstellung vom Polyurethan-Polyharnstoffdispersionen sind Verbindungen mit mindestens zwei gegenüber Isocyanaten reaktionsfähigen Wasserstoffatomen und einem mittleren Molekulargewicht von ≥62 bis ≤18000, bevorzugt ≥62 bis ≤4000 g/mol. Beispiele für geeignete Aufbaukomponenten sind Polyether, Polyester, Polycarbonat, Polylactone und Polyamide. Bevorzugte Polyole weisen ≥2 bis ≤4 bevorzugt ≥2 bis ≤3 Hydroxylgruppen auf. Auch Gemische verschiedener derartiger Verbindungen kommen in Frage.

Die Polyurethan-Polyharnstoff-Dispersion kann sowohl alleine als auch in Kombination mit einem oder mehreren hydrophil modifizierten Vernetzern verwendet werden. Die zusätzliche Vernetzung des Polyurethan-Polyharnstoff-Polymers bewirkt eine deutliche Erhöhung der Wärmebeständigkeit und der Hydrolysebeständigkeit der Klebeverbindung.

Auch eine oder mehrere latent-reaktive Polyurethan-Polyhamstoff-Dispersionen können eingesetzt werden. Latent-reaktive Polyurethan-Polyhamstoff-Dispersionen sind beispielsweise in EP 0 922 720 A und WO 2008/071307 beschrieben. Der Vorteil dieser Produktklasse liegt darin, dass die Vernetzungsreaktion des Polymers bei der ohnehin notwendigen Erwärmung der Aussparungen umfassenden Polymerschicht beim Laminierprozess ausgelöst wird.

Die Dispersion kann alleine oder mit den in der Beschichtungs- und Klebstofftechnologie bekannten Bindemitteln, Hilfsstoffen und/oder Zugschlagstoffen, insbesondere Emulgatoren und Lichtschutzmitteln, wie UV-Absorbern und sterisch gehinderte Aminen (HALS), Antioxidantien, Füllstoffen, Antiabsetzmitteln, Entschäumungsmitteln, Netzmitteln, Verlaufmitteln, Reaktiv-Verdünnem, Weichmachern, Neutralisationsmitteln, Katalysatoren, Hilfslösemitteln und/oder Verdickem und/oder Additiven, wie Pigmenten, Farbstoffen oder Mattierungsmitteln, eingesetzt werden. Auch Klebrigmacher ("Tackifier") können zugegeben werden. Die Additive können dabei unmittelbar vor der Verarbeitung zugegeben werden. Es ist aber auch möglich, zumindest einen Teil der Additive vor oder während der Dispergierung des Bindemittels zuzugeben.

Die Auswahl und die Dosierung dieser Stoffe, die den Einzelkomponenten und/oder der Gesamtmischung zugegeben werden können, sind dem Fachmann prinzipiell bekannt und können ohne ungebührlich hohen Aufwand auf den speziellen Anwendungsfall zugeschnitten durch einfache Vorversuche ermittelt werden.

Die Rheologie der wässrigen Polyurethandispersionen wird vorzugsweise mit geeigneten Verdickem so eingestellt, dass diese nach dem Aufbringen, beispielsweise auf die durchgehende Polymerschicht, nicht mehr verläuft. Insbesondere die Strukturviskosität der Fließgrenze kann dabei hoch sein. Der Einsatz einer derartigen wässrigen Polyurethandispersion hat den Vorteil, dass die Aussparungen umfassende Polymerschicht nach dem Aufbringen zunächst getrocknet werden kann, wobei das Polyurethanpolymer - in Abhängigkeit von dem eingesetzten Polymer oder Polymergemisch - amorph erstarrt und/oder kristallisiert und die Aussparungen umfassende Polymerschicht in einem nachfolgenden Laminierungsverfahren gerade soweit erwärmt werden kann, dass das Polyurethanpolymer erweicht und/oder schmilzt und die durchgehende Polymerschicht benetzt wird, wobei die Struktur der Aussparungen umfassenden Polymerschicht erhalten bleibt.

Die Druckfarbe, die Tinte, die Paste, die Formulierung, der Lack oder der Klebstoff beziehungsweise die erste und/oder zweite Aussparungen umfassende Polymerschicht kann jedoch auch einen reaktiven oder nicht-reaktiven Polyurethan-Schmelzklebstoff umfassen oder aus einem solchen ausgebildet sein.

Geeignete reaktive Polyurethan-Schmelzklebstoffe sind beispielsweise in DE 3827724, DE 4114229 und EP 354527 beschrieben. Diese Schmelzklebstoffe besitzen freie Isocyanat-Gruppen, die nach dem Aufbringen mit Feuchtigkeit aus dem Substrat vernetzen und so die geforderte Wärmebeständigkeit erreichen.

Die Polyurethan-Schmelzklebstoffe können alleine oder mit den in der Beschichtungs- und Klebstofftechnologie bekannten Bindemitteln, Hilfsstoffen und/oder Zugschlagstoffen, insbesondere Lichtschutzmitteln, wie UV-Absorbern und sterisch gehinderte Aminen (HALS), weiterhin Antioxidantien, Füllstoffen, Netzmitteln, Verlaufmitteln, Reaktiv-Verdünnern, Weichmachern, Neutralisationsmitteln, Katalysatoren, Hilfslösemitteln, klebrigmachenden Harzen (Tackifier) und/oder Additiven, wie Pigmenten, Farbstoffen oder Mattierungsmitteln, eingesetzt werden. Die Additive können dabei unmittelbar vor der Verarbeitung zugegeben werden. Es ist aber auch möglich, zumindest einen Teil der Additive vor oder während Herstellung des reaktiven Schmelzklebstoffes zuzugeben.

Die Auswahl und die Dosierung dieser Stoffe, die den Einzelkomponenten und/oder der Gesamtmischung zugegeben werden können, sind dem Fachmann prinzipiell bekannt und können ohne ungebührlich hohen Aufwand auf den speziellen Anwendungsfall zugeschnitten durch einfache Vorversuche ermittelt werden.

Geeignete nicht-reaktive Polyurethan-Schmelzklebstoffe sind beispielsweise in DE 1256822, DE 1930336 oder EP 192946 beschrieben. Weitere geeignete, nicht reaktive Schmelzklebstoffe sind Polyester und Copolyester, Polyamid, Polyolefme (APAO), Ethylenvinylacetat-Copolymere, Polyesterelastomere, Polyurethanelastomere und Copolyamidelastomere.

Vorzugsweise umfasst die Druckfarbe, die Tinte, die Paste, die Formulierung, der Lack oder der Klebstoff beziehungsweise die erste und/oder zweite Aussparungen umfassende Polymerschicht weiterhin mindestens ein Additiv zur Verbesserung der Elektret- und/oder elektromechanischen, beispielsweise piezoelektrischen, Eigenschaften. Das Additiv kann dabei jegliche Polymereigenschaften sowie Parameter verbessern, die eine Auswirkung auf die elektromechanischen, beispielsweise piezoelektrischen, Eigenschaften des Materials haben. Beispielsweise kann das Additiv die Dielektrizitätskonstante, den Elastizitätsmodul, das viskoelastische Verhalten, die Maximaldehnung und/oder die dielektrische Durchschlagsfestigkeit des Polymers beziehungsweise des Polymergemisches verbessern. Vorzugsweise wird ein Additiv eingesetzt, welches die Dielektrizitätskonstante und/oder die elektrische Leitfähigkeit und/oder das Elastizitätsmodul des Polymers erniedrigt und/oder die dielektrische Durchschlagsfestigkeit des Polymers erhöht. Beispielsweise können Tonpartikel, feine keramische Pulver und/oder Weichmacher wie Kohlenwasserstofföle, Mineralöle, Silikonöle und/oder Silikonelastomere, insbesondere mit hohem Molekulargewicht, als Additive eingesetzt werden. Durch die Auswahl von mehreren Additiven können vorteilhafterweise mehrere Materialeigenschaften gleichzeitig verbessert werden. Weiterhin kann Die Druckfarbe, die Tinte, die Paste, die Formulierung, der Lack oder der Klebstoff beziehungsweise die erste und/oder zweite Aussparungen umfassende Polymerschicht Additive umfassen, die das Aufbringen der Aussparungen umfassenden Polymerschicht vereinfachen. Dies sind beispielsweise Verlaufsadditive, Entschäumer und/oder Rheologieadditive sowie Zuschlagsstoffe zur Verbesserung der Eigenschaften der Aussparungen umfassenden Polymerschicht, wie Weichmacher.

Weiterhin kann die Druckfarbe, die Tinte, die Paste, die Formulierung, der Lack oder der Klebstoff beziehungsweise die erste und/oder zweite Aussparungen umfassende Polymerschicht, insbesondere vor der Fertigstellung des elektromechanischen Wandlers, auch Lösungsmittel umfassen. Beispiele hierfür sind Ethylacetat, Butylacetat, Methoxypropylacetat, Ethoxypropylacetat, Aceton, Cyclohexanon, Toluol, Xylol, Solvesso 100, Shellsol A und/oder Mischungen aus zwei oder mehreren dieser Lösungsmittel.

Bei der ersten und/oder zweiten und/oder dritten durchgehenden Polymerschichten handelt es sich vorzugsweise um kompakte Polymerschichten. Dabei bedeutet der Begriff "kompakt" im Sinn der vorliegenden Erfindung, dass die durchgehenden Polymerschichten möglichst wenige, insbesondere keine, Einschlüsse wie Gasblasen aufweisen. Insbesondere kann es sich bei den durchgehenden Polymerschichten um Polymerfilme handeln. Die erste und/oder zweite und/oder dritte durchgehende Polymerschicht können grundsätzlich unabhängig voneinander durch alle bekannten Verfahren zur Herstellung von, insbesondere dünnen, Schichten und Filmen hergestellt werden. Beispielsweise können die erste und/oder zweite und/oder dritte durchgehende Polymerschicht unabhängig voneinander über Extrusion, Rakeln, insbesondere Lösungsrakeln, Schleudern, insbesondere Lackschleudern, oder Sprühen hergestellt werden. Im Rahmen der vorliegenden Erfindung können jedoch auch kommerziell erhältliche durchgehende Polymerschichten beziehungsweise Polymerfilme als erste und/oder zweite und/oder dritte durchgehende Polymerschicht verwendet werden.

Im Rahmen der vorliegenden Erfindung können die erste und/oder zweite und/oder dritte durchgehende Polymerschicht unabhängig voneinander grundsätzlich aus jedem Polymer beziehungsweise Polymergemisch ausgebildet sein, welches geeignet ist, Ladung über einen langen Zeitraum, beispielsweise einige Monate oder Jahre, zu halten. Zum Beispiel können die erste und/oder zweite und/oder dritte durchgehende Polymerschicht fast beliebige, gleiche oder unterschiedliche Polymermaterialien umfassen oder daraus bestehen. Beispielsweise können die erste und/oder zweite und/oder dritte durchgehende Polymerschicht mindestens ein Polymer, ausgewählt aus der Gruppe bestehend aus Polycarbonaten, perfluorierten oder teilfluorierten Polymeren und Co-Polymeren, wie Polytetrafluoethylen (PTFE), Fluorethylenpropylen (FEP), Perfluoralkoxyethylenen (PFA), Polyestern, wie Polyethylenterephthalat (PET) oder Polyethylennaphthalat (PEN), Polyimiden, insbesondere Polyetherimid, Polyethern, Polymethylmethacrylaten, Cyclo-Olefin-Polymeren, Cyclo-Olefin-Copolymeren, Polyolefinen, wie Polypropylen, und Mischungen dieser Polymere umfassen oder daraus ausgebildet sein. Derartige Polymere können die eingebrachte Polarisierung vorteilhafterweise über lange Zeit halten. Geeignete Polycarbonate sind beispielsweise durch Reaktion von Kohlensäurederivaten, wie Diphenylcarbonat, Dimethylcarbonat oder Phosgen, mit Polyolen, bevorzugt Diolen, erhältlich. Beispiele für geeignete Diole sind dabei Ethylenglykol, 1,2- Propandiol, 1,3-Propandiol, 1,3-Butandiol, 1,4-Butandiol, 1,6-Hexandiol, 1,8-Octandiol, Neopentylglykol, 1,4-Bishydroxyrnethylcyclohexan, 2-Methyl-1,3-propandiol, 2,2,4-Trimethylpentandiol-1,3, Dipropylenglykol, Polypropylenglykole, Dibutylenglykol, Polybutylenglykole, Bisphenol A, Bisphenol F, Trimethyl-cyclohexyl-bisphenol (Bisphenol-TMC), Mischungen aus diesen und lactonmodifizierte Diole. Bevorzugt sind Polycarbonate hergestellt Bisphenol A, Bisphenol F, Trimethyl- cyclohexyl-bisphenol (Bisphenol-TMC) und Mischungen daraus und ganz besonders bevorzugt sind Polycarbonate basierend aus Bisphenol A. Darüber hinaus können die durchgehenden Polymerschichten unabhängig voneinander ein Homopolymer umfassen oder daraus ausgebildet sein.

Darüber hinaus können die erste und/oder zweite und/oder dritte durchgehende Polymerschicht mindestens ein Additiv zur Verbesserung der Elektret- und/oder elektromechanischen, beispielsweise piezoelektrischen, Eigenschaften umfassen. Das Additiv kann dabei jegliche Polymereigenschaften sowie Parameter verbessern, die eine Auswirkung auf die elektromechanischen, beispielsweise piezoelektrischen, Eigenschaften des Materials haben. Beispielsweise kann das Additiv die Elektreteigenschaften, die Dielektrizitätskonstante, den Elastizitätsmodul, das viskoelastische Verhalten, die Maximaldehnung und/oder die dielektrische Durchschlagsfestigkeit des Polymers beziehungsweise des Polymergemisches verbessern. Vorzugsweise werden ein Additiv oder mehrere Additive eingesetzt, welche die Elektreteigenschaften verbessern, das heißt, welche die Ladungsspeicherfähigkeit erhöhen, die elektrische Leitfähigkeit erniedrigen und/oder die dielektrische Durchschlagsfestigkeit des Polymers erhöhen. Beispielsweise können Tonpartikel, feine keramische Pulver und/oder Weichmacher wie Kohlenwasserstofföle, Mineralöle, Silikonöle und/oder Silikonelastomere, insbesondere mit hohem Molekulargewicht, als Additive eingesetzt werden. Durch die Auswahl von mehreren Additiven können vorteilhafterweise mehrere Materialeigenschaften gleichzeitig verbessert werden.

Die erste und/oder zweite und/oder dritte durchgehenden Polymerschicht können im Rahmen der vorliegenden Erfindung, insbesondere Im fertig gestellten elektromechanischen Wandler, unabhängig voneinander beispielsweise eine Schichtdicke von ≥10 µm bis ≤500 µm, beispielsweise von ≥20 µm bis ≤250 µm aufweisen.

Neben der ersten und/oder zweiten und/oder dritten durchgehenden Polymerschicht kann der erfindungsgemäße Wandler eine oder mehrere weitere durchgehende Polymerschichten aufweisen. Eine solche weitere, durchgehende Polymerschicht kann beispielsweise auf der Seite der ersten und/oder zweiten und/oder dritten durchgehenden Polymerschicht angeordnet sein, welche der angrenzenden Aussparungen umfassenden Polymerschicht gegenüber liegt.

Gegebenenfalls können die durchgängigen Polymerschichten vor dem Einsatz in dem erfmdungsgemäßen Verfahren oder im Rahmen des erfmdungsgemäßen Verfahrens getempert werden.

Das Verfahren kann weiterhin den Verfahrensschritt D): Aufbringen einer Elektrode auf die erste durchgehende Polymerschicht und einer Elektrode auf die Abdeckung, insbesondere auf die durchgehende Polymerschicht (zweite oder dritte) der Abdeckung, umfassen. Im Rahmen der vorliegenden Erfindung können die Elektroden jedoch auch bereits zusammen mit den ersten und/oder zweiten und/oder dritten durchgehenden Polymerschicht, insbesondere jeweils auf diesen ausgebildet, bereitgestellt werden.

Die Elektroden können mittels dem Fachmann bekannter Verfahren aufgebracht werden. Hierfür kommen beispielsweise Verfahren wie Sputtern, Aufdampfen, Chemical Vapor Deposition (CVD), Drucken, Rakeln, Spin-Coaten in Frage. Die Elektroden können auch in vorgefertigter Form aufgeklebt werden.

Bei den Elektrodenmaterialien kann es sich um dem Fachmann bekannte leitfähige Materialien handeln. Hierfür kommen beispielsweise Metalle, Metall-Legierungen, Halbleiter, leitfähige Oligo- oder Polymere, wie Polythiophene, Polyaniline, Polypyrrole, leitfähige Oxide oder Mischoxide, wie Indiumzinnoxid (ITO), oder mit leitfähigen Füllstoffen gefüllte Polymere in Frage. Als Füllstoffe für mit leitfähigen Füllstoffen gefüllte Polymere kommen beispielsweise Metalle, leitfähige Kohlenstoff basierende Materialien, beispielsweise Ruß, Kohlenstoffnanoröhrchen (Carbonanotubes (CNTs)), oder leitfähige Oligo- oder Polymere, in Frage. Der Füllstoffgehalt der Polymere liegt dabei vorzugsweise oberhalb der Perkolationsschwelle, welche dadurch gekennzeichnet ist, dass die leitfähigen Füllstoffe durchgehende elektrisch leitfähige Pfade ausbilden.

Die Elektroden können im Rahmen der vorliegenden Erfindung auch strukturiert sein. Beispielsweise können die Elektroden derart strukturiert sein, dass der Wandler aktive und passive Bereiche aufweist. Insbesondere können die Elektroden derart strukturiert sein, dass, insbesondere im Sensor-Modus, die Signale ortsaufgelöst detektiert und/oder, insbesondere im Aktuator-Modus, die aktiven Bereiche gezielt angesteuert werden können. Dies kann beispielsweise dadurch erzielt werden, dass die aktiven Bereiche mit Elektroden versehen sind, wohingegen die passiven Bereiche keine Elektroden aufweisen.

Das Verfahren kann weiterhin den Verfahrensschritt E): Aufladen der aus dem Verfahrensschritt C) hervorgehenden Anordnung, insbesondere Sandwich-Anordnung, umfassen. Insbesondere können dabei die erste durchgehende Polymerschicht und die Abdeckung, insbesondere die durchgehende Polymerschicht (zweite oder dritte) der Abdeckung mit Ladungen unterschiedlichen Vorzeichens aufgeladen werden. Das Aufladen kann beispielsweise durch Triboaufladung, Elektronenstrahlbeschuss, Anlegen einer elektrischen Spannung an die Elektroden oder Coronaentladung erfolgen. Insbesondere kann das Aufladen durch eine Zweielektroden-Corona-Anordnung erfolgen. Dabei kann die Nadelspannung mindestens ≥20 kV, beispielsweise mindestens ≥25 kV, insbesondere mindestens ≥30 kV, betragen. Die Aufladezeit kann dabei mindestens ≥20 s, beispielsweise mindestens ≥30 s, insbesondere mindestens ≥1 min, betragen. Im Rahmen der vorliegenden Erfindung kann sowohl erst Verfahrensschritt D) und dann Verfahrensschritt E) als auch erst Verfahrensschritt E) und dann Verfahrensschritt D) durchgeführt werden.

Das Verfahren kann weiterhin den Verfahrensschritt F): Aufeinander Stapeln von zwei oder mehr aus dem Verfahrensschritt C) hervorgehenden Anordnungen, insbesondere Sandwich-Anordnung, umfassen. Dabei können die erste durchgehende Polymerschicht und die Abdeckung, insbesondere die durchgehende Schicht (zwei oder drei) der Abdeckung, jeweils mit einer Elektrode kontaktiert werden. Vorzugsweise werden dabei zwei benachbarte, durchgehende Polymerschichten unterschiedlicher aus dem Verfahrensschritt C) hervorgehender Anordnungen mit einer gleichen Polarisation aufgeladen. Insbesondere können dabei zwei benachbarte, durchgehende Polymerschichten unterschiedlicher aus dem Verfahrensschritt C) hervorgehender Anordnungen die gleiche Elektrode kontaktieren oder mit der gleichen Elektrode kontaktiert werden.

Hinsichtlich weiterer Merkmale eines erfmdungsgemäßen Verfahrens wird hiermit explizit auf die Erläuterungen im Zusammenhang mit dem erfmdungsgemäßen elektromechanischen Wandler und dessen Verwendung verwiesen.

Ein weiterer Gegenstand der vorliegenden Erfindung ist ein elektromechanischer, beispielsweise piezoelektrischer, Wandler, insbesondere hergestellt durch ein erfindungsgemäßes Verfahren, welcher eine erste durchgehende Polymerschicht, eine erste Aussparungen umfassende Polymerschicht und eine Abdeckung umfasst, wobei die erste Aussparungen umfassende Polymerschicht zwischen der ersten durchgehenden Polymerschicht und der Abdeckung angeordnet ist, wobei die Aussparungen der ersten Aussparungen umfassenden Polymerschicht auf einer Seite durch die erste durchgehende Polymerschicht und auf der anderen Seite durch die Abdeckung unter Ausbildung von Hohlräumen verschlossen sind.

Da das erfindungsgemäße Herstellungsverfahren auf einem Druck- und/oder Beschichtungsverfahren beruht, können insbesondere die Oberflächen, welche die Aussparungen begrenzen, anders beschaffen sein als die Aussparungen begrenzenden Oberflächen von durch Bohren hergestellten Aussparungen. Zum Beispiel könnten die aus dem erfindungsgemäßen Verfahren resultierenden Aussparungen begrenzenden Oberflächen weniger Grate und andere scharfkantige Oberflächenunregelmäßigkeiten aufweisen, welche sich nicht in Kennwerte fassen lassen, aber dennoch eine, insbesondere negative, Auswirkung auf die elektromechanischen, insbesondere piezoelektrischen, Eigenschaften haben könnten.

In einer Ausführungsform des elektromechanischen Wandlers umfasst die Abdeckung eine zweite Aussparungen umfassende Polymerschicht und eine zweite durchgehende Polymerschicht, wobei die zweite durchgehende Polymerschicht auf der zweiten Aussparungen umfassenden Polymerschicht und die zweite Aussparungen umfassende Polymerschicht, insbesondere unter Ausbildung von gemeinsamen Hohlräumen, auf der ersten Aussparungen umfassenden Polymerschicht angeordnet ist.

In einer Ausführungsform des elektromechanischen Wandlers ist die Abdeckung eine dritte durchgehende Polymerschicht.

In einer Ausführungsform des elektromechanischen Wandlers umfasst die erste Aussparungen umfassende Polymerschicht in unterschiedlichen Formen ausgebildete Aussparungen und/oder umfasst die zweite Aussparungen umfassende Polymerschicht in unterschiedlichen Formen ausgebildete Aussparungen.

Wie bereits erläutert, kann durch eine Kombination aus in unterschiedlichen Formen ausgebildeten Aussparungen vorteilhafterweise zum einen das Gesamthohlraumvolumen der resultierenden Hohlräume maximiert werden und zum anderen die elektromechanischen, insbesondere piezoelektrischen, Eigenschaften angepasst werden.

Die Aussparungen der ersten Aussparungen umfassenden Polymerschicht und/oder die Aussparungen der zweiten Aussparungen umfassenden Polymerschicht können gegebenenfalls teilweise oder vollständig miteinander verbunden ausgebildet sein.

In einer Ausführungsfonn des elektromechanischen Wandlers ist zumindest ein Teil der Aussparungen der ersten Aussparungen umfassenden Polymerschicht in Formen ausgebildet, welche keine kreisförmige, insbesondere keine im Wesentlichen kreisförmige, Querschnittsfläche aufweisen, und/oder ist zumindest ein Teil der Aussparungen der zweiten Aussparungen umfassenden Polymerschicht in Formen ausgebildet, welche keine kreisförmige, insbesondere keine im Wesentlichen kreisförmige, Querschnittsfläche aufweisen.

Wie ebenfalls bereits erläutert, kann durch einen zumindest teilweisen Verzicht auf Aussparungen, welche eine kreisförmige, insbesondere eine im Wesentlichen kreisförmige, Querschnittsfläche aufweisen, das Gesamthohlraumvolumen vergrößert werden.

Die erste und zweite Aussparungen umfassende Polymerschicht können insbesondere deckungsgleich, insbesondere identisch, ausgebildet sein.

Die Aussparungen können in der ersten und/oder zweiten Aussparungen umfassenden Polymerschicht homogen oder heterogen verteilt ausgebildet sein. Insbesondere können die Aussparungen in der ersten und/oder zweiten Aussparungen umfassenden Polymerschicht homogen verteilt ausgebildet sein. In Abhängigkeit vom Anwendungsbereich des herzustellenden elektromechanischen Wandlers, kann es jedoch auch vorteilhaft sein, die Aussparungen in der ersten und/oder zweiten Aussparungen umfassenden Polymerschicht, insbesondere gezielt, ortsaufgelöst heterogen verteil auszubilden.

Vorzugsweise sind die Aussparungen der ersten Aussparungen umfassenden Polymerschicht durchgängig, insbesondere in Richtung auf die durchgehenden Polymerschichten, durch die erste Aussparungen umfassende Polymerschicht ausgebildet; und/oder die Aussparungen der zweiten Aussparungen umfassenden Polymerschicht durchgängig, insbesondere in Richtung auf die durchgehenden Polymerschichten, durch die zweite Aussparungen umfassende Polymerschicht ausgebildet.

Die erste und/oder zweite Aussparungen umfassende Polymerschicht kann eine Vielzahl an in einer ersten Form ausgebildeten Aussparungen und eine Vielzahl an in einer zweiten Form ausgebildeten Aussparungen und gegebenenfalls eine Vielzahl an in einer dritten Form ausgebildeten Aussparungen, et cetera, aufweisen. Dabei können in unterschiedlichen Formen ausgebildete Aussparungen in der ersten und/oder zweiten Aussparungen umfassenden Polymerschicht homogen oder heterogen verteilt und/oder teilweise oder vollständig miteinander verbunden ausgebildet sein.

Im Rahmen der vorliegenden Erfindung können die Aussparungen zum Beispiel teilweise oder vollständig in Formen ausgebildet sein, welche eine Querschnittsfläche ausgewählt aus der Gruppe bestehend aus im Wesentlichen runden, beispielsweise kreisförmigen, elliptischen oder ovalen, polygonen, beispielsweise dreieckigen, rechteckigen, trapezförmigen, rautenförmigen, fünfeckigen, sechseckigen, insbesondere wabenförmigen, kreuzförmigen, sternförmigen und teilweise runden und teilweise polygonen, beispielsweise S-förmigen, Querschnittsflächen, aufweisen. Vorzugsweise weisen die Aussparungen der ersten und/oder zweiten Aussparungen aufweisenden Schicht eine wabenförmige Querschnittsfläche auf beziehungsweise sind wabenförmig ausgebildet und/oder angeordnet. Eine wabenförmig Ausbildung und Anordnung der Aussparungen hat zum einen ein sehr großes Gesamthohlraumvolumen zur Folge. Zum anderen kann eine wabenförmig Ausbildung und Anordnung der Aussparungen eine hohe mechanische Stabilität aufweisen.

Die Größe der Querschnittsflächen kann bei allen Aussparungen der Aussparungen umfassenden Polymerschicht gleich oder unterschiedlich sein.

Die erste und/oder zweite Aussparungen umfassende Polymerschicht können beispielsweise jeweils eine Schichtdicke von ≥1 µm bis ≤800 µm, insbesondere von ≥10 µm bis ≤400 µm, aufweisen. Insofern der elektromechanische Wandler nur eine erste Aussparungen umfassende Polymerschicht aufweist, so kann die erste Aussparungen umfassende Polymerschicht eine Schichtdicke von ≥ 1 µm bis ≤800 µm, beispielsweise von ≥10 µm bis ≤400 µm, aufweisen. Insofern der elektromechanische Wandlers sowohl eine erste als auch eine zweite Aussparungen umfassende Polymerschicht aufweist, so kann die gemeinsame Schichtdicke der ersten Aussparungen umfassenden Polymerschicht und der zweiten Aussparungen umfassenden Polymerschicht ≥1 µm bis ≤800 µm, beispielsweise von ≥10 µm bis ≤400 µm, betragen.

Die erste und/oder zweite und/oder dritte durchgehenden Polymerschicht können beispielsweise unabhängig voneinander beispielsweise eine Schichtdicke von ≥10 µm bis ≤500 µm, beispielsweise von ≥20 µm bis ≤250 µm aufweisen.

Die erste und/oder zweite Aussparungen umfassende Polymerschicht kann beispielsweise mindestens ein Polymer ausgewählt aus der Gruppe bestehend aus Celluloseestern, Celluloseethern, Kautschukderivaten, Polyesterharzen, ungesättigten Polyestern, Alkydharzen, Phenolharzen, Aminoharzen, Amidoharzen, Ketonharzen, Xylol-Formaldehydharzen, Epoxidharze, Phenoxyharzen, Polyolefmen, Polyvinylchlorid, Polyvinylestern, Polyvinylalkoholen, Polyvinylacetalen, Polyvinylethern, Polyacrylaten, Polymetacrylaten, Polystyrolen Polycarbonaten, Polyestern, Copolyestern, Polyamiden, Silikonharzen, Polyurethanen, insbesondere Polyurethanen, und Mischungen dieser Polymere umfassen beziehungsweise daraus ausgebildet sein. Insbesondere kann die erste und/oder zweite Aussparungen umfassende Polymerschicht ein oder mehrere Einkomponenten-Polyurethane und/oder ein oder mehrere Zweikomponenten-Polyurethane und/oder einen oder mehrere Polyurethan-Schmelzklebstoffe umfassen oder daraus ausgebildet sein.

Die erste und/oder zweite und/oder dritte durchgehende Polymerschicht kann beispielsweise mindestens ein Polymer, ausgewählt aus der Gruppe bestehend aus Polycarbonaten, perfluorierten oder teilfluorierten Polymeren und Co-Polymeren, wie Polytetrafluoethylen (PTFE), Fluorethylenpropylen (FEP), Perfluoralkoxyethylenen (PFA), Polyestern, wie Polyethylenterephthalat (PET) oder Polyethylennaphthalat (PEN), Polyimiden, insbesondere Polyetherimid, Polyethern, Polymethylmethacrylaten, Cyclo-Olefin-Polymeren, Cyclo-Olefin-Copolymeren, Polyolefmen, wie Polypropylen, und Mischungen dieser Polymere umfassen oder daraus ausgebildet sein.

Vorzugsweise umfasst ein elektromechanischer Wandler weiterhin zwei Elektroden, insbesondere Elektrodenschichten, wobei eine Elektrode die erste durchgehende Polymerschicht und die andere Elektrode die Abdeckung, insbesondere die durchgehende Polymerschicht (zweite oder dritte) der Abdeckung, kontaktiert. Weiterhin können die erste durchgehende Polymerschicht und die Abdeckung, insbesondere die durchgehende Polymerschicht (zweite oder dritte) der Abdeckung, eine elektrische Ladung mit unterschiedlichem Vorzeichen aufweisen. Insbesondere kann ein erfindungsgemäßer elektromechanischer Wandler zwei oder mehr aufeinander gestapelte Anordnungen, insbesondere Sandwich-Anordnung, umfassen, welche jeweils eine erste durchgehende Polymerschicht, eine erste Aussparungen umfassende Polymerschicht und eine Abdeckung umfassen, wobei die erste Aussparungen umfassende Polymerschicht zwischen der ersten durchgehenden Polymerschicht und der Abdeckung angeordnet ist und wobei die Aussparungen der ersten Aussparungen umfassenden Polymerschicht auf einer Seite durch die erste durchgehende Polymerschicht und auf der anderen Seite durch die Abdeckung unter Ausbildung von Hohlräumen verschlossen sind. Dabei können die erste durchgehende Polymerschicht und die Abdeckung, insbesondere die durchgehende Schicht (zwei oder drei) der Abdeckung, jeweils eine Elektrode kontaktieren. Vorzugsweise weisen dabei zwei benachbarte, durchgehende Polymerschichten unterschiedlicher Anordnungen die gleiche Ladungspolarisation auf. Insbesondere können dabei zwei benachbarte, durchgehende Polymerschichten unterschiedlicher Anordnungen die gleiche Elektrode kontaktieren.

Hinsichtlich weiterer Merkmale eines erfindungsgemäßen elektromechanischen Wandlers wird hiermit explizit auf die Erläuterungen im Zusammenhang mit dem erfindungsgemäßen Verfahren und der erfindungsgemäßen Verwendung verwiesen.

Ein weiterer Gegenstand der vorliegenden Erfindung ist die Verwendung eines erfindungsgemäßen Wandlers als Sensor, Generator und/oder Aktuator, beispielsweise im elektromechanischen und/oder elektroakustischen Bereich, insbesondere im Bereich der Energiegewinnung aus mechanischen Schwingungen (Energy-Harvesting), der Akustik, des Ultraschalls, der medizinischen Diagnostik, der akustischen Mikroskopie, der mechanischen Sensorik, insbesondere Druck- Kraft- und/oder Dehnungssensorik, der Robotik und/oder der Kommunikationstechnologie, insbesondere in Lautsprechern, Schwingungswandlern, Lichtdeflektoren, Membranen, Modulatoren für Glasfaseroptik, pyroelektrischen Detektoren, Kondensatoren und Kontrollsystemen.

Hinsichtlich weiterer Merkmale einer erfindungsgemäßen Verwendung wird hiermit explizit auf die Erläuterungen im Zusammenhang mit dem erfindungsgemäßen Verfahren und dem erfindungsgemäßen elektromechanischen Wandler verwiesen.

### Zeichnungen und Versuchsbeschreibung

Die erfindungsgemäße Herstellung und der Aufbau eines erfindungsgemäßen elektromechanischen, beispielsweise piezoelektrischen, Wandlers wird anhand der Zeichnungen, der folgenden Zeichnungsbeschreibung und der folgenden Versuchsbeschreibungen näher erläutert. Dabei ist zu beachten, dass die Zeichnungen und die Versuchsbeschreibungen nur einen beschreibenden Charakter haben und nicht dazu gedacht sind, die Erfindung in irgendeiner Form einzuschränken.

### Zeichnungen

Es zeigen:
- Fig. 1a: einen schematischen Querschnitt durch eine erste, auf einer ersten durchgehenden Polymerschicht aufgebrachte Aussparungen umfassende Polymerschicht;
- Fig. 1b: einen schematischen Querschnitt durch eine Form einer Abdeckung, welche eine zweite Aussparungen umfassende Polymerschicht und eine zweite durchgehende Polymerschicht umfasst;
- Fig. 1c: einen schematischen Querschnitt durch die in den Fig. 1a gezeigte Schichtanordnung, auf welche die in Fig. 1b gezeigte Abdeckung aufgebracht wurde;
- Fig. 2a: einen schematischen Querschnitt durch eine erste, auf einer ersten durchgehenden Polymerschicht aufgebrachte Aussparungen umfassende Polymerschicht;
- Fig. 2b: einen schematischen Querschnitt durch die in Fig. 2a gezeigte Schichtanordnung, auf welcher eine Abdeckung in Form einer dritten durchgehenden Polymerschicht aufgebracht wurde;
- Fig. 3a: einen schematischen Querschnitt durch die in Fig. 2b gezeigte Anordnung nach dem Aufladungsprozess;
- Fig. 3b: einen schematischen Querschnitt durch die in Fig. 2b gezeigte Anordnung nach dem Aufladungsprozess und nach dem Anbringen von Elektroden;
- Fig. 4: einen schematischen Querschnitt durch einen erfindungsgemäßen Wandler mit drei aufeinander gestapelten Anordnungen, welche jeweils eine erste durchgehende Polymerschicht, eine erste Aussparungen umfassende Polymerschicht und eine Abdeckung in Form einer dritten durchgehenden Polymerschicht umfassen; und
- Fig. 5a-5i: Draufsichten auf verschiedene Ausführungsformen von Aussparungen umfassenden Polymerschichten.

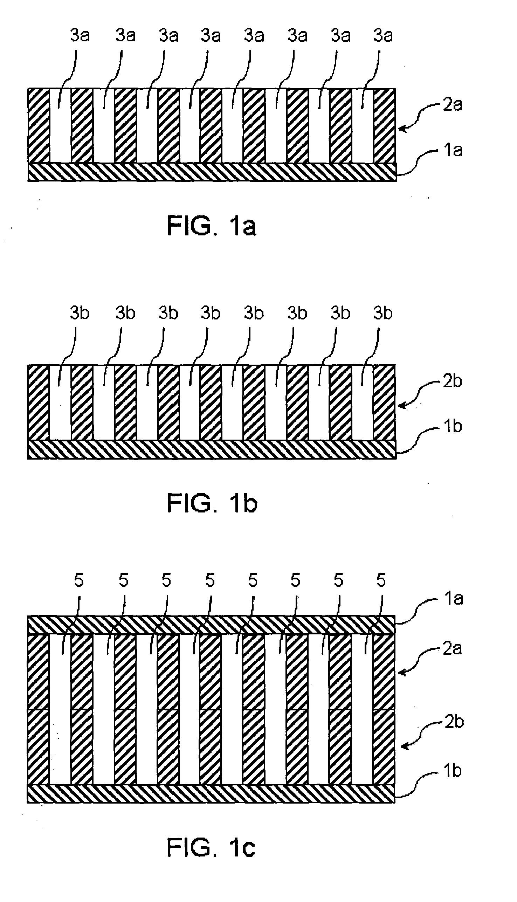

Figur 1a zeigt einen schematischen Querschnitt durch eine erste durchgehende Polymerschicht 1a, auf der eine erste Aussparungen 3a umfassende Polymerschicht 2a aufgebracht wurde.

Figur 1b zeigt einen schematischen Querschnitt durch eine Form einer Abdeckung, welche eine zweite Aussparungen 3b umfassende Polymerschicht 2b und eine zweite durchgehende Polymerschicht 1b umfasst.

Figur 1c zeigt einen schematischen Querschnitt durch die in der Figur 1a gezeigte Schichtanordnung, auf welche die in Figur 1b gezeigte Abdeckung aufgebracht wurde. Figur 1c veranschaulicht, dass die Aussparungen 3a der ersten Aussparungen 3a umfassenden Polymerschicht 2a und die Aussparungen 3b der zweiten Aussparungen 3b umfassenden Polymerschicht 2b so ausgebildet und angeordnet sind, dass nach dem Aufbringen der Abdeckung 1b, 2b auf die erste Aussparungen 3a umfassende Polymerschicht 2a jeweils eine Aussparung 3a der ersten Aussparungen 3a umfassenden Polymerschicht 2a und eine Aussparung 3b der zweiten Aussparungen 3b umfassenden Polymerschicht 2b vollständig unter Ausbildung eines gemeinsamen Hohlraums 5 überlappen.

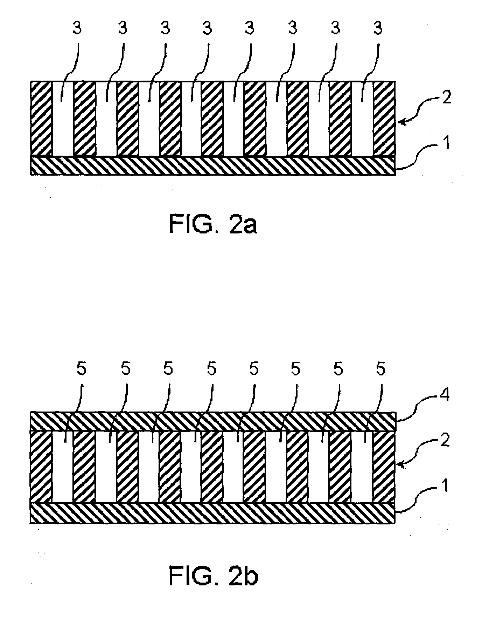

Figur 2a zeigt einen schematischen Querschnitt durch eine erste durchgehende Polymerschicht 1, auf der eine erste Aussparungen 3 umfassende Polymerschicht 2 aufgebracht wurde. Figur 2 a veranschaulicht, dass die Aussparungen 3 der ersten Aussparungen umfassenden Polymerschicht durchgängig durch die Aussparungen 3 umfassende Polymerschicht 2 ausgebildet sind.

Figur 2b zeigt, dass auf die erste Aussparungen 3 umfassende Polymerschicht 2 der in Fig. 1a gezeigten Schichtanordnung eine Abdeckung in Form einer dritten durchgehenden Polymerschicht 4 aufgebracht wurde. Figur 2b veranschaulicht, dass dabei die Aussparungen 3 der ersten Aussparungen 3 umfassenden Polymerschicht 2 auf der einen Seite durch die erste durchgehende Polymerschicht 1 und auf der anderen Seite durch die dritte durchgehende Polymerschicht 4 unter Ausbildung von Hohlräumen verschlossen wurden.

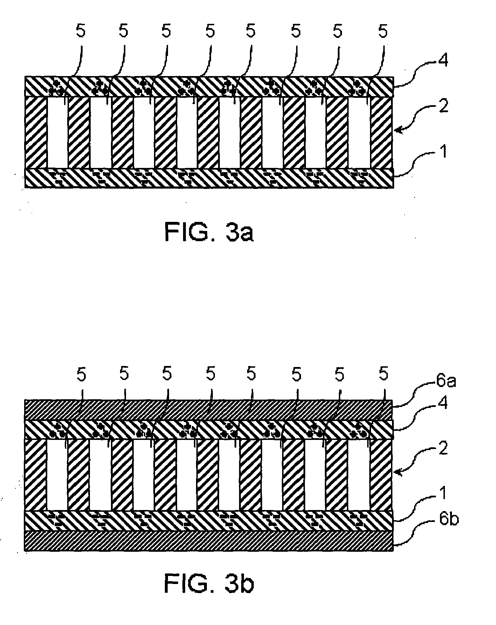

Figur 3a zeigt einen schematischen Querschnitt durch die in Figur 2b gezeigte Anordnung und veranschaulicht die Ladungsverteilung nach dem Aufladen der in Figur 2b gezeigten Anordnung.

Figur 3a veranschaulicht, dass die negativen Ladungen auf der ersten durchgehenden Polymerschicht 1 und die positiven Ladungen auf der dritten durchgehenden Polymerschicht 4 lokalisiert sind.

Figur 3b zeigt einen schematischen Querschnitt durch die in Figur 2b gezeigte Anordnung nach dem Aufladungsprozess und nach dem Anbringen von Elektroden. Die erste 1 und dritte 4 durchgehende Polymerschicht kontaktieren jeweils eine Elektrode 6a, 6b. De Elektroden 6a, 6b sind dabei als Elektrodenschichten jeweils auf den Seiten der ersten 1 und dritten 4 Polymerschicht ausgebildet, welche gegenüberliegend zu den Seiten, an denen die Hohlräume 5 ausbildende, Aussparungen umfassende Polymerschicht 2 angrenzt, angeordnet sind.

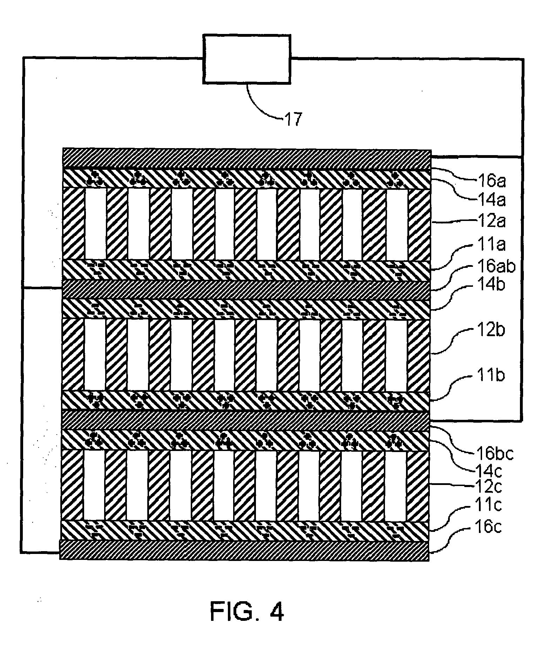

Figur 4 zeigt einen schematischen Querschnitt durch einen erfmdungsgemäßen Wandler mit drei aufeinander gestapelten Anordnungen, welche jeweils eine erste durchgehende Polymerschicht 11a, 11b, 11c, eine erste Aussparungen umfassende Polymerschicht 12a, 12b, 12c und eine Abdeckung in Form einer dritten durchgehenden Polymerschicht 14a, 14b, 14c umfassen. Figur 4 veranschaulicht, dass zwei benachbarte durchgehende Polymerfilme 11a, 14b; 11b, 14c unterschiedlicher Anordnungen mit einer gleichen Polarisation aufgeladen sind und dabei die gleiche Elektrode 16ab; 16bc kontaktieren. Figur 4 zeigt darüber hinaus eine Möglichkeit des Anschlusses der Elektroden 16a, 16ab, 16bc, 16c an eine Spannungs/Strom-Mess/Versorgungs/Speicher-Vorrichtung 17.

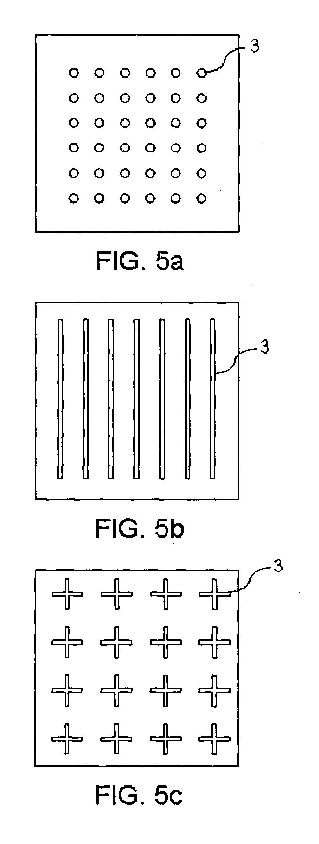

Die Figuren 5a bis 5i zeigen verschiedene Ausführungsformen von Aussparungen 3 umfassenden Polymerschichten und Aussparungsausgestaltungen. Die in den Figuren 5a bis 5i gezeigten Ausführungsformen und Ausgestaltungen stellen jedoch nur Beispiele dar und sind nicht dazu gedacht, die Erfindung in irgendeiner Form einzuschränken. Aus Gründen der Übersichtlichkeit ist in den Figuren 5a bis 5i jeweils nur eine Aussparung einer Form beispielhaft mit einem Bezugszeichen gekennzeichnet.

Figur 5a zeigt eine Aussparungen 3 umfassende Polymerschicht, deren Aussparungen eine kreisförmige Querschnittfläche aufweisen. Figur 5a veranschaulicht darüber hinaus, dass durch das erfindungsgemäße Verfahren eine Vielzahl von kleinen Aussparungen 3 ausgebildet werden kann.

Figur 5b zeigt eine Aussparungen 3 umfassende Polymerschicht, deren Aussparungen 3 eine längliche, rechteckige Querschnittfläche aufweisen. Figur 5b veranschaulicht ebenfalls, dass durch das erfindungsgemäße Verfahren eine Vielzahl von kleinen Aussparungen 3 ausgebildet werden kann.

Figur 5c zeigt eine Aussparungen 3 umfassende Polymerschicht, deren Aussparungen 3 eine kreuzförmige Querschnittfläche aufweisen.

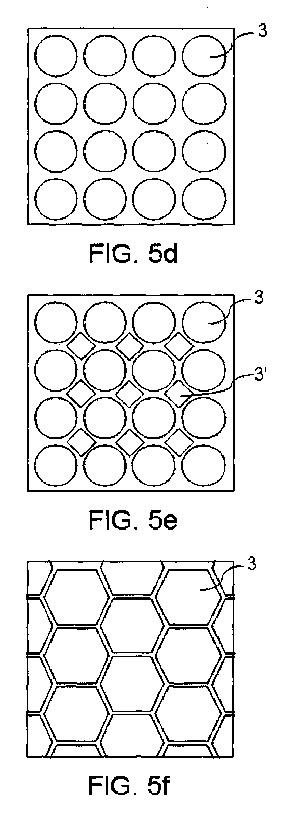

Figur 5d zeigt eine Aussparungen 3 umfassende Polymerschicht, deren Aussparungen 3 eine kreisförmige Querschnittfläche aufweisen. Figur 5d veranschaulicht, dass beim ausschließlichen Einsatz von Aussparungen 3 mit kreisförmigen Querschnittsflächen kein optimales Gesamthohlraumvolumen erzielt werden kann.

Figur 5e zeigt eine Aussparungen 3, 3' umfassende Polymerschicht, deren Aussparungen teilweise eine kreisförmige Querschnittfläche 3 und teilweise eine rautenförmige Querschnittsfläche 3' aufweisen. Figur 5e veranschaulicht, dass bei einer homogen verteilten Anordnung von Aussparungen mit kreisförmigen 3 und rautenförmigen 3' Querschnittsflächen ein größeres Gesamthohlraumvolumen erzielt werden kann als bei dem in Figur 5d gezeigten, ausschließlichen Einsatz von Aussparungen 3 mit kreisförmigen Querschnittsflächen.

Figur 5f zeigt eine Aussparungen 3 umfassende Polymerschicht, deren Aussparungen 3 eine wabenförmige Querschnittfläche aufweisen. Figur 5f veranschaulicht, dass durch eine Anordnung, welche ausschließlich auf Aussparungen 3 mit wabenförmigen Querschnittsflächen basiert, ein deutlich größeres Gesamthohlraumvolumen erzielt werden kann als bei dem in Figur 5d gezeigten, ausschließlichen Einsatz von Aussparungen 3 mit kreisförmigen Querschnittsflächen.

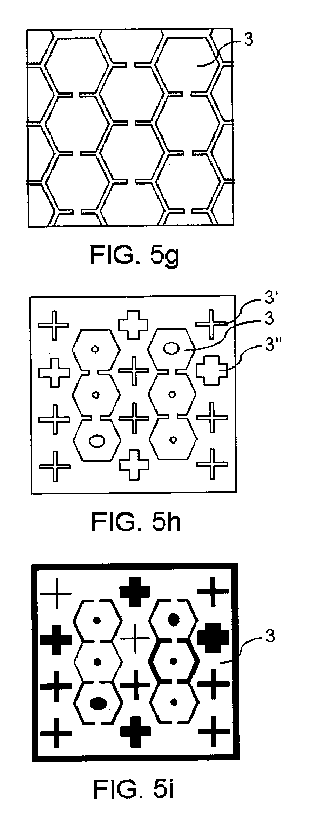

Figur 5g zeigt eine Aussparungen 3 umfassende Polymerschicht, deren Aussparungen 3 eine wabenförmige Querschnittfläche aufweisen und teilweise miteinander verbunden ausgebildet sind.

Figur 5h zeigt eine Aussparungen 3, 3', 3" umfassende Polymerschicht, deren Aussparungen in unterschiedlichen Formen und Größen ausgebildet sind und die kreuzförmige 3', 3" und im wesentlichen wabenförmige 3 Querschnittflächen aufweisen. Figur 5h zeigt weiterhin, dass die Aussparungen unhomogen verteilt und teilweise miteinander verbunden ausgebildet sind.

Figur 5i zeigt eine Aussparungen 3 umfassende Polymerschicht, deren Aussparungen 3 durch Aufbringen einer Kombination unterschiedlicher Strukturen, insbesondere von Sechsecken/Waben, Kreuzen und Punkten unterschiedlicher Punkt- und Linienstärke, auf eine durchgehende Polymerschicht 1 durch ein Druck- und/oder Beschichtungsverfahren ausgebildet wurden. Figur 5i zeigt weiterhin, dass zumindest die Randbereiche der durchgehenden Polymerschicht mit einer geschlossenen Struktur bedruckt und/oder beschichtet sein können, um nach Abschluss des erfindungsgemäßen Herstellungsverfahrens einen oder mehr abgeschlossene, mit den durchgehenden Polymerschichten in Kontakt stehende Hohlräume zu erhalten. Auf diese Weise kann ein zusammenhängender Hohlraum ausgebildet werden. Figur 5i veranschaulicht weiterhin, dass im Rahmen der vorliegenden Erfmdung unter einer Aussparungen aufweisenden Polymerschicht auch eine Polymerschicht verstanden werden kann, welche nur eine Aussparung 3 aufweist, insbesondere welche auch als Zusammenschluss beziehungsweise Verbindung von mehreren Aussparungen verstanden werden kann.

### Beispiele

### Versuchsbeschreibung

### Beispiel 1

Zur Herstellung einer Aussparungen umfassenden Polymerschicht durch ein Siebdruckverfahren wurde eine erste Siebdruckpaste formuliert. Diese enthielt 47,14 Gewichtsprozent Desmodur^{®} N75 MPA und 52,11 Gewichtsprozent Desmophen^{®} 670. Um den Verlauf der Paste und die Blasenbildung während des Drucks zu reduzieren, wurden der Formulierung 0,75 Gewichtsprozent Verlaufsmittel (BYK 410 50 % in Butoxyl) zugesetzt.

### Beispiel 2

Zur Herstellung einer weiteren Aussparungen umfassenden Polymerschicht durch ein Siebdruckverfahren wurde eine zweite Siebdruckpaste formuliert. In dieser wurden 40,40 Gewichtsprozent Desmodur^{®} N75 MPA, 44,59 Gewichtsprozent Desmophen^{®} 670, 11,26 Gewichtsprozent Ethoxypropylacetat, 3,30 Gewichtsprozent Verlaufsmittel und 0,45 Gewichtsprozent einer 1:1 Mischung von BYK 410 mit Butoxyl verwendet.

Mehrere Siebdruckexperimente haben ergeben, dass mit den Siebdruckpasten nach Beispiel 1 und 2 sowohl einmal eine Druckschicht als auch nacheinander mehrer Druckschichten aufgebracht werden können. Insbesondere kann dabei eine Druckschicht auf eine noch nicht vollständig verfestigte, vorherige Druckschicht aufgetragen werden (Nass-in-nass-Verfahren). Es hat sich gezeigt, dass zur Erhöhung der Schichtdicke mehrere Druckschritte mit Zwischentrocknung durchgeführt werden können. Zum Beispiel kann auf einer durchgehenden Polycarbonatfolie zweimal eine Druckschicht im Nass-in-nass-Verfahren mit Zwischentrocknung aufgebracht werden. Zum Druck wurden Gewebe mit 12 bis 200 Fäden pro Zentimeter, vorzugsweise mit 22 bis 120 Fäden pro Zentimeter, verwendet. Um bei feinen Strukturen eine gute Schichtdicke zu erreichen, wurde ein Gewebe mit 90 Fäden pro Zentimeter eingesetzt. Auf diese Weise ließen sich mit einem Nass-in-nass-Druck Schichtdicken von 7 µm und 12 µm und mit einem zweifachen Nass-in-nass-Druck mit Zwischentrocknung Schichtdicken von 15 µm bis 25 µm erzielen.

## Patentansprüche

1. Verfahren zur Herstellung eines elektromechanischen Wandlers, umfassend die Schritte:
A) Aufbringen einer ersten Aussparungen (3;3a) umfassenden Polymerschicht (2;2a) auf eine erste durchgehende Polymerschicht (1;1a) mittels eines Druck- und/oder Beschichtungsverfahrens;
B) Aufbringen einer Abdeckung (4;1b,2b) auf die erste Aussparungen (3;3a) umfassende Polymerschicht (2;2a), so dass die Aussparungen (3;3a) der ersten Aussparungen (3;3a) umfassenden Polymerschicht (2;2a) unter Ausbildung von Hohlräumen (5) verschlossen werden; und
C) Verbinden der Abdeckung (4;1b,2b) mit der ersten Aussparungen (3;3a) umfassenden Polymerschicht (2;2a).

2. Verfahren nach Anspruch 1, wobei
- die Abdeckung eine zweite Aussparungen (3b) umfassende Polymerschicht (2b) und eine zweite durchgehende Polymerschicht (1b) umfasst, wobei die zweite Aussparungen (3b) umfassende Polymerschicht (2b) auf der zweiten durchgehende Polymerschicht (1b) angeordnet ist, oder
- die Abdeckung eine dritte durchgehende Polymerschicht (4) ist.

3. Verfahren nach Anspruch 2, wobei die Abdeckung durch Aufbringen einer zweiten Aussparungen (3b) umfassenden Polymerschicht (2b) auf eine zweite durchgehende Polymerschicht (1b) mittels eines Druck- und/oder Beschichtungsverfahrens hergestellt wird.

4. Verfahren nach Anspruch 1, wobei das Verbinden der ersten Aussparungen (3, 3a) umfassenden Polymerschicht (2, 2a) mit der Abdeckung (4;1b,2b) durch ein Laminierungsverfahren erfolgt.

5. Verfahren nach Anspruch 1 oder 3, wobei das Verbinden der ersten Aussparungen (3;3a) umfassenden Polymerschicht (2;2a) mit der Abdeckung (4;1b,2b) durch
- nur teilweises Verfestigen des Materials der ersten Aussparungen (3;3a) umfassenden Polymerschicht (2;2a) nach dem Aufbringen auf die erste durchgehende Polymerschicht (1;1a) und/oder
- nur teilweises Verfestigen des Materials der zweiten Aussparungen (3b) umfassenden Polymerschicht (2b) nach dem Aufbringen auf die zweite durchgehende Polymerschicht (1b), und
- weiteres Verfestigen des Materials der ersten Aussparungen (3;3a) umfassenden Polymerschicht (2;2a) nach dem Aufbringen der Abdeckung (4;1b,2b), und/oder
- weiteres Verfestigen des Materials der zweiten Aussparungen (3b) umfassenden Polymerschicht (2b) nach dem Aufbringen der Abdeckung (4;1b,2b)
erfolgt.

6. Verfahren nach Anspruch 1 oder 3, wobei das Aufbringen der ersten Aussparungen (3;3a) umfassenden Polymerschicht (2;2a) und/oder das Aufbringen der zweiten Aussparungen (3b) umfassenden Polymerschicht (2b) durch Rakeln, Lackschleudem, Tauchlackieren, Srühlackieren, Vorhanggießen, Beschichtung mittels Düsenauftrag, Flexodruck, Gravurdruck, Tampondruck, Digitaldruck, Thermotransferdruck, Durchdruck, ein Walzenauftragsverfahren und /oder durch ein Siebdruckverfahren erfolgt.

7. Verfahren nach Anspruch 1 oder 2, wobei die Aussparungen (3;3a) der ersten Aussparungen (3;3a) umfassenden Polymerschicht (2;2a) durchgängig durch die erste Aussparungen (3;3a) umfassenden Polymerschicht (2;2a) ausgebildet sind und/oder die Aussparungen (3b) der zweiten Aussparungen (3b) umfassenden Polymerschicht (2b) durchgängig durch die zweite Aussparungen (3b) umfassende Polymerschicht (2b) ausgebildet sind.

8. Verfahren nach Anspruch 2, wobei die Aussparungen (3a) der ersten Aussparungen (3a) umfassenden Polymerschicht (2a) und die Aussparungen (3b) der zweiten Aussparungen (3b) umfassenden Polymerschicht (2b) so ausgebildet und angeordnet sind, dass beim Aufbringen der Abdeckung (1b,2b) jeweils eine Aussparung (3a) der ersten Aussparungen (3a) umfassenden Polymerschicht (2a) und eine Aussparung (3b) der zweiten Aussparungen (3b) umfassenden Polymerschicht (2b) teilweise oder vollständig überlappen.

9. Verfahren nach Anspruch 1 oder 2, wobei die erste Aussparungen (3;3a) umfassende Polymerschicht (2; 2a) und/oder die zweite Aussparungen (3b) umfassende Polymerschicht (2b) in unterschiedlichen Formen ausgebildete Aussparungen (3;3a,3b), bevorzugt wabenförmig ausgebildete und/oder angeordnete Aussparungen (3;3a,3b) umfasst.

10. Verfahren nach Anspruch 1 oder 2, wobei
- die erste Aussparungen (3;3a) umfassende Polymerschicht (2;2a) und/oder die zweite Aussparungen (3b) umfassende Polymerschicht (2b) mindestens ein Polymer, ausgewählt aus der Gruppe bestehend aus Celluloseestern, Celluloseethern, Kautschukderivaten, Polyesterharzen, ungesättigten Polyestern, Alkydharzen, Phenolharzen, Aminoharzen, Amidoharzen, Ketonharzen, Xylol-Formaldehydharzen, Epoxidharzen, Phenoxyharzen, Polyolefmen, Polyvinylchlorid, Polyvinylestern, Polyvinylalkoholen, Polyvinylacetalen, Polyvinylethern, Polyacrylaten, Polymetacrylaten, Polystyrolen, Polycarbonaten, Polyestern, Copolyestern, Polyamiden, Silikonharzen, Polyurethanen und Mischungen dieser Polymere, umfasst, und/oder
- die erste durchgehende Polymerschicht (1;1a) und/oder die zweite durchgehende Polymerschicht (1b) und/oder die dritte durchgehende Polymerschicht (4) mindestens ein Polymer, ausgewählt aus der Gruppe bestehend aus Polycarbonaten, perfluorierten oder teilfluorierten Polymeren und Co-Polymeren, Polyestern, Polyimiden, Polyethern, Polymethylmethacrylaten, Cyclo-Olefm-Polymeren, Cyclo-Olefin-Copolymeren, Polyolefinen und Mischungen dieser Polymere, umfasst.

11. Verfahren nach Anspruch 1 oder 2, wobei
- die erste Aussparungen (3;3a) umfassende Polymerschicht (2;2a) im fertig gestellten elektromechanischen Wandler eine Schichtdicke von ≥1 µm bis ≤800 µm aufweist, und/oder die zweite Aussparungen (3b) umfassende Polymerschicht (2b) im fertig gestellten elektromechanischen Wandler eine Schichtdicke von ≥1 µm bis ≤800 µm aufweist, und/oder
- die erste durchgehende Polymerschicht (1;1a) und/oder die zweite durchgehende Polymerschicht (1b) und/oder die dritte durchgehende Polymerschicht (4) eine Schichtdicke von ≥10 µm bis ≤500 µm aufweist.

12. Verfahren nach Anspruch 1 oder 2, wobei die erste Aussparungen (3;3a) umfassende Polymerschicht (2;2a) und/oder die zweite Aussparungen (3b) umfassende Polymerschicht (2b) ein oder mehrere Einkomponenten-Polyurethane und/oder ein oder mehrere Zweikomponenten-Polyurethane und/oder eine oder mehrere wässrige Polyurethandispersionen und/oder einen oder mehrere Polyurethan-Schmelzklebstoffe umfasst.

13. Elektromechanischer Wandler, hergestellt durch ein Verfahren nach Anspruch 1 oder 2, umfassend
- eine erste durchgehende Polymerschicht (1;1a),
- eine erste Aussparungen (3;3a) umfassende Polymerschicht (2;2a), und
- eine Abdeckung (4;1b,2b),
wobei die erste Aussparungen (3;3a) umfassende Polymerschicht (2;2a) zwischen der ersten durchgehenden Polymerschicht (1;1a) und der Abdeckung (4;1b,2b) angeordnet ist, und
wobei die Aussparungen (3;3a) der ersten Aussparungen (3;3a) umfassenden Polymerschicht (2;2a) auf einer Seite durch die erste durchgehende Polymerschicht (1;1a) und auf der anderen Seite durch die Abdeckung (4;1b,2b) unter Ausbildung von Hohlräumen (5) verschlossen sind.

14. Elektromechanischer Wandler nach Anspruch 13, wobei
- die Abdeckung eine zweite Aussparungen (3b) umfassende Polymerschicht (2b) und eine zweite durchgehende Polymerschicht (1b) umfasst, wobei die zweite durchgehende Polymerschicht (1b) auf der zweiten Aussparungen (3b) umfassenden Polymerschicht (2b) und die zweite Aussparungen (3b) umfassende Polymerschicht (2b) auf der ersten Aussparungen (3a) umfassenden Polymerschicht (2a) angeordnet ist, oder
- die Abdeckung eine dritte durchgehende Polymerschicht (4) ist.

15. Elektromechanischer Wandler nach Anspruch 14, wobei die erste Aussparungen (3;3a) umfassende Polymerschicht (2;2a) in unterschiedlichen Formen ausgebildete Aussparungen (3;3a) umfasst und/oder die zweite Aussparungen (3b) umfassende Polymerschicht (2b) in unterschiedlichen Formen ausgebildete Aussparungen (3b) umfasst, bevorzugt zumindest ein Teil der Aussparungen (3;3a) der ersten Aussparungen (3;3a) umfassenden Polymerschicht (2;2a) in Formen ausgebildet ist, welche keine kreisförmige Querschnittsfläche aufweisen, und/oder zumindest ein Teil der Aussparungen (3b) der zweiten Aussparungen (3b) umfassenden Polymerschicht (2b) in Formen ausgebildet ist, welche keine kreisförmige Querschnittsfläche aufweisen.
